(19) Europäisches Patentamt
European Patent Office
Office européen des brevets

(11) **EP 4 697 039 A1**

(12) **EUROPEAN PATENT APPLICATION**
published in accordance with Art. 153(4) EPC

(43) Date of publication:
**18.02.2026 Bulletin 2026/08**

(21) Application number: **23933325.5**

(22) Date of filing: **17.04.2023**

(51) International Patent Classification (IPC):
*G01R 31/389* (2019.01)

(52) Cooperative Patent Classification (CPC):
**G01R 31/389**

(86) International application number:
**PCT/CN2023/088722**

(87) International publication number:
**WO 2024/216444 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Contemporary Amperex Future Energy Research Institute (Shanghai) Limited**
**Shanghai 200241 (CN)**
• **Contemporary Amperex Technology Co., Limited**
**Ningde, Fujian 352100 (CN)**

(72) Inventor: **QIAN, Mu**
**Shanghai 200241 (CN)**

(74) Representative: **Gong, Jinping**
**CocreateIP**
**Neumarkter Straße 21**
**81673 München (DE)**

(54) **ELECTROCHEMICAL IMPEDANCE SPECTRUM MEASUREMENT METHOD, SYSTEM, AND DEVICE, AND READABLE STORAGE MEDIUM**

(57) This application provides an electrochemical impedance spectrum measurement method, system, and apparatus, and a readable storage medium. The method includes: inputting an excitation signal used for measuring EIS to a battery in an electric apparatus, acquiring a current value sequence and a voltage value sequence of the battery during a process of inputting the excitation signal to the battery, and determining the electrochemical impedance spectrum of the battery based on the current value sequence and the voltage value sequence. This method does not require configuration of a separate detection apparatus for batteries, which can reduce the EIS measurement cost while maintaining operational simplicity, making it highly practical for actual applications.

```
┌─────────────────────────────────────────────────────────────┐
│ Input an alternating current excitation signal to a first     │── 21
│ battery in the electric apparatus                             │
└─────────────────────────────────────────────────────────────┘
                            │
                            ▼
┌─────────────────────────────────────────────────────────────┐
│ Acquire a current value sequence and a voltage value sequence │── 22
└─────────────────────────────────────────────────────────────┘
                            │
                            ▼
┌─────────────────────────────────────────────────────────────┐
│ Determine an electrochemical impedance spectrum of the first  │── 23
│ battery based on the current value sequence and the voltage    │
│ value sequence                                                │
└─────────────────────────────────────────────────────────────┘
```

FIG. 2

EP 4 697 039 A1

## Description

## TECHNICAL FIELD

This application relates to the field of battery technology, and specifically, to an electrochemical impedance spectrum measurement method, system, and apparatus, and a readable storage medium.

## BACKGROUND TECHNOLOGY

As an electrical energy storage apparatus, batteries are widely used in various electric apparatuses. As the power source for electric apparatuses, the condition of the battery affects whether the electric apparatus can operate safely, stably, and reliably. Therefore, it is highly necessary to monitor the condition of the battery during use of the battery.

The impedance characteristics of a battery are closely related to the state of charge (state of charge, SOC), state of health (state of health, SOH), internal temperature, and the like of the battery. During monitoring of the condition of a battery, electrochemical impedance spectrum (electrochemical impedance spectrum, EIS) of the battery is monitored, and the impedance characteristics of the battery are analyzed based on the EIS, thereby accurately determining the condition of the battery.

In related technologies, the EIS of a battery is primarily monitored using a specialized monitoring apparatus. However, such monitoring apparatus is complicated, costly, and lacks practical application capability. Therefore, there is an urgent need for an EIS measurement method with practical application capability to monitor the EIS of batteries.

## SUMMARY

The purpose of the embodiments of this application is to provide an electrochemical impedance spectrum measurement method, system, and apparatus, and a readable storage medium, including but not limited to addressing the prior-art problem of lacking a simple, low-cost method to measure electrochemical impedance spectrum of batteries using.

According to a first aspect, an electrochemical impedance spectrum measurement method is provided. The method includes:

inputting an excitation signal to a first battery in an electric apparatus, where the excitation signal is used to measure an electrochemical impedance spectrum of the first battery;
acquiring a current value sequence and a voltage value sequence, where the current value sequence includes current values of the first battery during a process of inputting the excitation signal to the first battery, and the voltage value sequence includes voltage values of the first battery during the process of inputting the excitation signal to the first battery; and
determining the electrochemical impedance spectrum of the first battery based on the current value sequence and the voltage value sequence.

In the embodiments of this application, during measurement of the electrochemical impedance spectrum of a battery, there is no need to configure a separate detection apparatus for the battery. This can reduce the electrochemical impedance spectrum measurement cost while maintaining the operation simplicity. Therefore, the EIS measurement method provided in the embodiments of this application is highly practical in actual applications.

In one embodiment, the determining the electrochemical impedance spectrum of the first battery based on the current value sequence and the voltage value sequence includes:

in a case that the voltage value sequence includes a voltage value corresponding to an identification signal, determining a voltage value subsequence corresponding to the excitation signal from the voltage value sequence;
in a case that the current value sequence includes a current value corresponding to an identification signal, determining a current value subsequence corresponding to the excitation signal from the current value sequence; and
determining the electrochemical impedance spectrum based on the voltage value subsequence and the current value subsequence.

In the implementation of this application, during the process of determining the electrochemical impedance spectrum based on the current value sequence and the voltage value sequence, the voltage value subsequence corresponding to the excitation signal is extracted from the voltage value sequence, and the current value subsequence corresponding to the excitation signal is extracted from the current value sequence. Since the current value subsequence and the voltage value subsequence are the voltage values and current values of the battery under the action of the excitation signal, determining the electrochemical impedance spectrum based on the current value subsequence and the voltage value subsequence can avoid introducing other voltage values and current values, thereby improving the accuracy of the electrochemical impedance spectrum.

In one embodiment, after the determining the electrochemical impedance spectrum of the first battery based on the current value sequence and the voltage value sequence, the method further includes: adjusting a charging policy of the first battery based on the electrochemical impedance spectrum.

In the embodiments of this application, after the electrochemical impedance spectrum of the first battery is determined, the charging policy of the first battery can be adjusted based on the electrochemical impedance spectrum of the first battery. Since the state of the first battery can be determined relatively accurately based on the electrochemical impedance spectrum, adjusting the charging policy of the first battery based on the electrochemical impedance spectrum allows for more accurate control of the charging process of the first battery.

In one embodiment, after the determining the electrochemical impedance spectrum of the first battery based on the current value sequence and the voltage value sequence, the method further includes: outputting state information of the first battery, where the state information is determined based on the electrochemical impedance spectrum.

In the embodiments of this application, after the electrochemical impedance spectrum of the first battery is determined, the state information of the first battery can be output based on the electrochemical impedance spectrum of the first battery. Since the state of the first battery can be accurately determined based on the electrochemical impedance spectrum, relatively accurate state information can be output based on the electrochemical impedance spectrum, facilitating users in judging the state of the first battery based on the state information.

According to a second aspect, an electrochemical impedance spectrum measurement system is provided. The measurement system includes: a charging apparatus and an electric apparatus; where

the charging apparatus is configured to input an excitation signal to a first battery in the electric apparatus, where the excitation signal is used to measure an electrochemical impedance spectrum of the first battery;

the charging apparatus is further configured to acquire a current value sequence and a voltage value sequence, where the current value sequence includes current values of the first battery during a process of inputting the excitation signal to the first battery, and the voltage value sequence includes voltage values of the first battery during the process of inputting the excitation signal to the first battery; and

the charging apparatus is further configured to determine the electrochemical impedance spectrum based on the current value sequence and the voltage value sequence.

In the embodiments of this application, the charging apparatus inputs the excitation signal to the battery in the electric apparatus and determines the electrochemical impedance spectrum based on the voltage value sequence and the current value sequence. This eliminates the need to configure a separate detection apparatus for the battery, thereby reducing the electrochemical impedance spectrum measurement cost. Additionally, the connection between the charging apparatus and the electric apparatus is a conventional connection, and the operation is relatively simple. Therefore, the EIS measurement method provided in the embodiments of this application is highly practical in actual applications.

In one embodiment, the charging apparatus is specifically configured to acquire the current value sequence and the voltage value sequence sampled by the electric apparatus from the electric apparatus; or, the charging apparatus is specifically configured to acquire one of the current value sequence and the voltage value sequence sampled by the electric apparatus from the electric apparatus and perform sampling to obtain the other of the current value sequence and the voltage value sequence; or, the charging apparatus is specifically configured to perform sampling to obtain the current value sequence and the voltage value sequence.

In the embodiments of this application, after the electrochemical impedance spectrum of the first battery is determined, the state information of the first battery can be output based on the electrochemical impedance spectrum of the first battery. Since the state of the first battery can be accurately determined based on the electrochemical impedance spectrum, relatively accurate state information can be output based on the electrochemical impedance spectrum, facilitating users in judging the state of the first battery based on the state information.

According to a third aspect, an electrochemical impedance spectrum measurement system is provided. The measurement system includes: a charging apparatus and an electric apparatus; where

the charging apparatus is configured to input an excitation signal to a first battery in the electric apparatus, where the excitation signal is used to measure an electrochemical impedance spectrum of the first battery;

the electric apparatus is configured to acquire a current value sequence and a voltage value sequence, where the current value sequence includes current values of the first battery during a process of inputting the excitation signal to the first battery, and the voltage value sequence includes voltage values of the first battery during the process of inputting the excitation signal to the first battery; and

the electric apparatus is further configured to determine the electrochemical impedance spectrum based on the current value sequence and the voltage value sequence.

In the embodiments of this application, the charging apparatus inputs the excitation signal to the battery in the electric apparatus, and the electric apparatus determines the electrochemical impedance spectrum based on the voltage value sequence and the current value sequence. This eliminates the need to configure a separate detection apparatus for the battery, thereby reducing the electrochemical impedance spectrum measurement cost. Moreover, the electric apparatus directly determines the electrochemical impedance spectrum through calculation, facilitating the electric apparatus in promptly obtaining the battery state based on the electrochemical impedance spectrum and adjusting the charging policy.

In one embodiment, the electric apparatus is specifically configured to acquire the current value sequence and the voltage value sequence sampled by the charging apparatus from the charging apparatus; or, the electric apparatus is specifically configured to acquire one of the current value sequence and the voltage value sequence sampled by the charging apparatus from the charging apparatus and perform sampling to obtain the other of the current value sequence and the voltage value sequence; or, the electric apparatus is specifically configured to perform sampling to obtain the current value sequence and the voltage value sequence.

In the embodiments of this application, when the voltage value sequence and the current value sequence of the first battery are obtained through sampling by the electric apparatus, since the voltage values and current values sampled by the electric apparatus are relatively accurate, the EIS calculated based on the voltage value sequence and the current value sequence can be improved. When one of the voltage value sequence and the current value sequence is sampled by the electric apparatus and the other is sampled by the charging apparatus, the sampling method for the voltage values and current values can be flexibly set according to needs. When the voltage value sequence and the current value sequence of the first battery are obtained through sampling by the electric apparatus, the electric apparatus does not need to send the voltage value sequence and the current value sequence to the charging apparatus during the charging process, simplifying the interaction process between the electric apparatus and the charging apparatus.

According to a fourth aspect, an electrochemical impedance spectrum measurement system is provided. The measurement system includes: a charging apparatus, an electric apparatus, and a server; where

the charging apparatus is configured to input an excitation signal to a first battery in the electric apparatus, where the excitation signal is used to measure an electrochemical impedance spectrum of the first battery;

the server is configured to acquire a current value sequence and a voltage value sequence, where the current value sequence includes current values of the first battery during a process of inputting the excitation signal to the first battery, and the voltage value sequence includes voltage values of the first battery during the process of inputting the excitation signal to the first battery; and

the server is further configured to determine the electrochemical impedance spectrum based on the current value sequence and the voltage value sequence.

In the embodiments of this application, the charging apparatus inputs the excitation signal to the battery in the electric apparatus, and the server determines the electrochemical impedance spectrum based on the voltage value sequence and the current value sequence. This eliminates the need to configure a separate detection apparatus for the battery, thereby reducing the electrochemical impedance spectrum measurement cost. Moreover, the server directly determines the electrochemical impedance spectrum through calculation, facilitating the server in determining the state of the battery in the electric apparatus based on the electrochemical impedance spectrum, thereby implementing effective management of the electric apparatus based on the apparatus of the battery.

In one embodiment, the server is specifically configured to acquire the current value sequence and the voltage value sequence from the charging apparatus or the electric apparatus; or, the server is specifically configured to acquire one of the current value sequence and the voltage value sequence sampled by the charging apparatus from the charging apparatus and acquire the other of the current value sequence and the voltage value sequence sampled by the electric apparatus from the electric apparatus.

In the embodiments of this application, when the voltage value sequence and the current value sequence of the first battery are obtained through sampling by the electric apparatus, since the voltage values and current values sampled by the electric apparatus are relatively accurate, the EIS calculated based on the voltage value sequence and the current value sequence can be improved. When one of the voltage value sequence and the current value sequence is sampled by the electric apparatus and the other is sampled by the charging apparatus, the sampling method for the voltage values and current values can be flexibly set according to needs.

In one embodiment, the charging apparatus includes a measurement module, where the measurement module is configured to connect to the first battery to input the excitation signal to the first battery.

In one embodiment, the measurement module includes a signal generator for generating the excitation signal.

In the embodiments of this application, when the measurement module includes a signal generator, the signal generator can transform the voltage of the power source in the charging apparatus to generate the excitation signal. The implementation of the signal generator is relatively simple, which can reduce the development difficulty of the charging apparatus.

In one embodiment, the charging apparatus further includes a power source and a voltage transformation module; where the voltage transformation module has an input terminal connected to the power source, and an output terminal connected to the first battery, and is configured to transform a voltage from the power source to obtain and input a charging current to the first battery.

In the embodiments of this application, when the charging apparatus further includes a power source and a voltage transformation module, the charging apparatus can charge the battery in the electric apparatus through the voltage transformation module, and the electrochemical impedance spectrum of the battery in the electric apparatus is measured during the charging process.

In one embodiment, the power source includes a second battery.

In the embodiments of this application, when the power source in the charging apparatus includes a second battery, the charging apparatus can store energy through the second battery to charge the charging apparatus in the case of a power outage, ensuring the power demand of the charging apparatus during a power outage.

According to a fifth aspect, an electrochemical impedance spectrum measurement method is provided, applied to a charging apparatus. The method includes:

> inputting an excitation signal to a first battery in an electric apparatus;
> where the excitation signal is used to measure an electrochemical impedance spectrum of the first battery.

In the embodiments of this application, the charging apparatus inputs the excitation signal to the battery in the electric apparatus and determines the electrochemical impedance spectrum based on the excitation signal. During measurement of the electrochemical impedance spectrum of the battery, there is no need to configure a separate detection apparatus for the battery, thereby reducing the electrochemical impedance spectrum measurement cost. Additionally, the connection between the charging apparatus and the electric apparatus is a conventional connection, and the operation is relatively simple. Therefore, the EIS measurement method provided in the embodiments of this application is highly practical in actual applications.

In one embodiment, before the inputting an excitation signal to a first battery in an electric apparatus, the method further includes: inputting a first identification signal to the first battery, where the first identification signal is used to identify the start of inputting the excitation signal to the first battery.

In the embodiments of this application, when determining the EIS of the first battery, the charging apparatus can determine, from the current value sequence and the voltage value sequence based on the voltage value and current value corresponding to the first identification signal, the current value and voltage value that are at a same sampling time point and correspond to the excitation signal, implementing alignment of the voltage value and current value corresponding to the excitation signal. The impedance of the battery is determined based on the aligned voltage value and current value, so that a more accurate impedance can be calculated, thereby obtaining a more accurate electrochemical impedance spectrum.

In one embodiment, after the inputting an excitation signal to a first battery in an electric apparatus, the method further includes:
inputting a second identification signal to the first battery, where the second identification signal is used to identify the stop of inputting the excitation signal to the first battery.

In the embodiments of this application, after inputting the excitation signal to the first battery, the charging apparatus inputs the second identification signal to the first battery. In determining the EIS of the first battery, voltage values unrelated to the excitation signal can be removed from the voltage value sequence based on the voltage value corresponding to the second identification signal, and current values unrelated to the excitation signal can be removed from the current value sequence based on the current value corresponding to the second identification signal, improving the accuracy of the current value and voltage value corresponding to the excitation signal, thereby obtaining a more accurate electrochemical impedance spectrum.

In one embodiment, duration of the identification signal input by the charging apparatus to the first battery is greater than or equal to a preset number of sampling periods of the excitation signal.

In one embodiment, the preset number is 3.

In the embodiments of this application, the duration of the identification signal input by the charging apparatus to the first battery is not less than the preset number of sampling periods of the excitation signal. In sampling the voltage and current corresponding to the excitation signal, the sampled current value sequence and voltage value sequence can include a larger number of voltage values and current values corresponding to the identification signal, allowing for more accurate differentiation between the voltage values and current values corresponding to the identification signal and the excitation signal from the current value sequence and the voltage value sequence.

In one embodiment, the identification signal input by the charging apparatus to the first battery includes any one of a single-pulse signal, a multi-pulse signal, a step signal, a triangular wave signal, and a trapezoidal wave signal.

In the embodiments of this application, since the voltage values and current values corresponding to identification signals such as single-pulse signals, multi-pulse signals, step signals, triangular wave signals, and trapezoidal wave signals are easily recognizable, when the identification signal is one of the above signals, the voltage value corresponding to the excitation signal and the voltage value corresponding to the identification signal can be easily distinguished.

In one embodiment, the inputting an excitation signal to a first battery in an electric apparatus includes: inputting the excitation signal to the first battery at preset intervals; or inputting the excitation signal to the first battery in a case that a state of charge of the first battery reaches a preset threshold.

In the embodiments of this application, during measurement of the electrochemical impedance spectrum of the first battery, the charging apparatus can input the excitation signal to the first battery at preset intervals, or input the excitation signal to the first battery in a case that the state of charge of the first battery reaches the preset threshold, reducing the duration of measuring the EIS of the first battery, thereby reducing the power consumption of the charging apparatus.

In one embodiment, the method further includes:

> acquiring a current value sequence and a voltage value sequence of the first battery; and
> determining the electrochemical impedance spectrum based on the current value sequence and the voltage value sequence.

In the embodiments of this application, during the process of inputting the excitation signal to the electric apparatus, the charging apparatus acquires the voltage value sequence and the current value sequence of the first battery under the action of the excitation signal and determines the EIS of the first battery based on the voltage value sequence and the current value sequence, facilitating the charging apparatus in promptly obtaining the EIS of the first battery when connected to the electric apparatus, allowing for a timely response when an abnormality in the first battery is detected based on the EIS of the first battery.

In one embodiment, the acquiring a current value sequence and a voltage value sequence of the first battery includes:

> acquiring the current value sequence and the voltage value sequence sampled by the electric apparatus from the electric apparatus;
> or, acquiring one of the current value sequence and the voltage value sequence sampled by the electric apparatus from the electric apparatus and performing sampling to obtain the other of the current value sequence and the voltage value sequence;
> or, performing sampling to obtain the current value sequence and the voltage value sequence.

In the embodiments of this application, when the voltage value sequence and the current value sequence of the first battery are obtained through sampling by the electric apparatus, since the voltage values and current values sampled by the electric apparatus are relatively accurate, the EIS calculated based on the voltage value sequence and the current value sequence can be improved. When one of the voltage value sequence and the current value sequence is sampled by the electric apparatus and the other is sampled by the charging apparatus, the sampling method for the voltage values and current values can be flexibly set according to needs. When the voltage value sequence and the current value sequence of the first battery are obtained through sampling by the electric apparatus, the electric apparatus does not need to send the voltage value sequence and the current value sequence to the charging apparatus during the charging process, simplifying the interaction process between the electric apparatus and the charging apparatus.

In one embodiment, the method further includes: sending the acquired current value sequence and/or voltage value sequence of the first battery to a server.

In the embodiments of this application, the charging apparatus sends one or both of the voltage value sequence and the current value sequence to the server, and the server determines the electrochemical impedance spectrum of the first battery based on the current value sequence and the voltage value sequence, reducing the computational load on the charging apparatus.

According to a sixth aspect, an electrochemical impedance spectrum measurement method is provided. The method includes:

> acquiring a current value sequence and a voltage value sequence, where the current value sequence includes current values of a first battery during a process of inputting an excitation signal to the first battery in an electric apparatus, the voltage value sequence includes voltage values of the first battery during the process of inputting the excitation signal to the first battery, and the excitation signal is input to the first battery by a charging apparatus; and
> determining an electrochemical impedance spectrum of the first battery based on the current value sequence and the voltage value sequence.

In one embodiment, the determining an electrochemical impedance spectrum of the first battery based on the current value sequence and the voltage value sequence includes:

> in a case that the voltage value sequence includes a voltage value corresponding to an identification signal, determining a voltage value subsequence corresponding to the excitation signal from the voltage value sequence;
> in a case that the current value sequence includes a current value corresponding to an identification signal, determining a current value subsequence corresponding to the excitation signal from the current value sequence; and

determining the electrochemical impedance spectrum based on the voltage value subsequence and the current value subsequence.

In one embodiment, the method is applied to a server, and the acquiring a current value sequence and a voltage value sequence includes:

acquiring the current value sequence and the voltage value sequence from the electric apparatus or the charging apparatus;

or, acquiring the current value sequence from one of the electric apparatus and the charging apparatus and acquiring the voltage value sequence from the other.

In one embodiment, the method further includes: adjusting a charging policy of the first battery based on the electrochemical impedance spectrum.

In one embodiment, the method further includes: outputting state information of the first battery, where the state information is determined based on the electrochemical impedance spectrum.

According to a seventh aspect, an electrochemical impedance spectrum measurement apparatus is provided. The apparatus includes a measurement module; and

the measurement module is configured to input an excitation signal to a first battery in an electric apparatus;

where the excitation signal is used to measure an electrochemical impedance spectrum of the first battery.

In one embodiment, the measurement module is further configured to input an identification signal to the first battery.

In one embodiment, the measurement module is specifically configured to input the excitation signal to the first battery at preset intervals; or input the excitation signal to the first battery in a case that a state of charge of the first battery reaches a preset threshold.

In one embodiment, the apparatus further includes:

an acquisition module configured to acquire a current value sequence and a voltage value sequence of the first battery; and

a determining module configured to determine the electrochemical impedance spectrum based on the current value sequence and the voltage value sequence.

In one embodiment, the apparatus further includes: an adjustment module for adjusting a charging policy of the first battery based on the electrochemical impedance spectrum.

In one embodiment, the apparatus further includes: an output module configured to output state information of the first battery, where the state information is determined based on the electrochemical impedance spectrum.

In one embodiment, the apparatus further includes:
a sending module configured to send the acquired current value sequence and/or voltage value sequence of the first battery to a server.

In one embodiment, the measurement module includes a signal generator, where the signal generator is configured to connect to the first battery and input the excitation signal to the first battery.

In one embodiment, the apparatus further includes a power source and a voltage transformation module; where
the voltage transformation module has an input terminal connected to the power source, and an output terminal connected to the first battery, and is configured to transform a voltage from the power source to obtain and input a charging current to the first battery.

In one embodiment, the power source includes a second battery.

According to an eighth aspect, an electrochemical impedance spectrum measurement apparatus is provided. The measurement apparatus includes:

an acquisition module configured to acquire a current value sequence and a voltage value sequence, where the current value sequence includes current values of a first battery during a process of inputting an excitation signal to the first battery in an electric apparatus, the voltage value sequence includes voltage values of the first battery during the process of inputting the excitation signal to the first battery, and the excitation signal is input to the first battery by a charging apparatus; and

a determining module configured to determine an electrochemical impedance spectrum of the first battery based on the current value sequence and the voltage value sequence.

In one embodiment, the apparatus further includes: an adjustment module configured to adjust a charging policy of the first battery based on the electrochemical impedance spectrum.

In one embodiment, the apparatus further includes: an output module configured to output state information of the first battery, where the state information is determined based on the electrochemical impedance spectrum.

According to a ninth aspect, a readable storage medium is provided. The readable storage medium is configured to store a computer program, and when the computer program is executed by an electrochemical impedance spectrum measurement apparatus, the electrochemical impedance spectrum measurement apparatus is caused to perform the method according to the fifth aspect or the sixth aspect.

According to a tenth aspect, a computer program product is provided, including: a computer program, where when the computer program is executed on an electrochemical impedance spectrum measurement apparatus, the electrochemical impedance spectrum measurement apparatus is caused to perform the electrochemical impedance spectrum measurement method according to any possible implementation of the fifth aspect or the sixth aspect.

According to an eleventh aspect, a chip is provided, including: a processor configured to call and execute a computer program from a memory, to cause an electrochemical impedance spectrum measurement apparatus installed with the chip to perform the electrochemical impedance spectrum measurement method according to any possible implementation of the fifth aspect or the sixth aspect.

It can be understood that the electrochemical impedance spectrum measurement apparatus according to the fourth aspect and the fifth aspect, the readable storage medium according to the sixth aspect, the computer program product according to the seventh aspect, and the chip according to the eighth aspect are all used to perform the electrochemical impedance spectrum measurement method according to the first aspect or the second aspect. Therefore, for the beneficial effects they can achieve, reference may be made to the beneficial effects in the corresponding methods provided above, and details are not repeated herein.

## DESCRIPTION OF THE DRAWINGS

To more clearly illustrate the technical solutions in the embodiments of this application, the drawings required for use in the embodiments or exemplary technical descriptions will be briefly introduced below. It is apparent that the drawings described below are only some embodiments of this application, and for those of ordinary skill in the art, other drawings can be obtained based on these drawings without creative effort.

FIG. 1 is a schematic diagram of a scenario for measuring an electrochemical impedance spectrum according to an embodiment of this application.
FIG. 2 is a flowchart of an electrochemical impedance spectrum measurement method according to an embodiment of this application.
FIG. 3 is a schematic structural diagram of a charging apparatus according to an embodiment of this application.
FIG. 4 is a schematic structural diagram of an electrochemical impedance spectrum measurement system according to an embodiment of this application.
FIG. 5 is a schematic structural diagram of another electrochemical impedance spectrum measurement system according to an embodiment of this application.

FIG. 6 is a flowchart of an electrochemical impedance spectrum measurement method according to an embodiment of this application.
FIG. 7 is a schematic structural diagram of still another electrochemical impedance spectrum measurement system according to an embodiment of this application.
FIG. 8 is a schematic diagram of signal changes according to an embodiment of this application.
FIG. 9 is another schematic diagram of signal changes according to an embodiment of this application.
FIG. 10 is still another schematic diagram of signal changes according to an embodiment of this application.
FIG. 11 is a flowchart of another electrochemical impedance spectrum measurement method according to an embodiment of this application.
FIG. 12 is a schematic structural diagram of another electrochemical impedance spectrum measurement system according to an embodiment of this application.
FIG. 13 is a flowchart of still another electrochemical impedance spectrum measurement method according to an embodiment of this application.
FIG. 14 is a schematic structural diagram of still another electrochemical impedance spectrum measurement system according to an embodiment of this application.
FIG. 15 is a flowchart of still another electrochemical impedance spectrum measurement method according to an embodiment of this application.
FIG. 16 is a schematic structural diagram of an electrochemical impedance spectrum measurement apparatus according to an embodiment of this application.
FIG. 17 is a structural block diagram of an electrochemical impedance spectrum measurement apparatus according to an embodiment of this application.

Reference signs:

1. detection apparatus; 11. signal generator; 12. current sensor; 13. voltage sensor; 14. computer;
2. battery;
3. charging apparatus; 31. control module; 32. measurement module; 33. voltage transformation module; 34. power source; 35. sensor module; 351. current sensor; 352. voltage sensor; 36. charging input interface; 37. charging output interface; 38. voltage module;
4. electric apparatus; 41. first battery; 42. charging input interface; 43. battery management system; and

5. server.

## DETAILED DESCRIPTION

The embodiments of the technical solutions of this application will be described in detail below in conjunction with the drawings. The following embodiments are only used to more clearly illustrate the technical solutions of this application and are therefore only exemplary, not intended to limit the scope of protection of this application.

Unless otherwise defined, all technical and scientific terms used herein have the same meaning as commonly understood by those skilled in the technical field of this application; the terms used herein are only for the purpose of describing specific embodiments and are not intended to limit this application; the terms "including" and "having" and any variations thereof in the specification, claims, and the above description of the drawings of this application are intended to cover non-exclusive inclusion.

In the description of the embodiments of this application, the technical terms such as "first" and "second" are only used to distinguish different objects and should not be understood as indicating or implying relative importance or implicitly indicating the number, specific order, or primary-secondary relationship of the technical features indicated. In the description of the embodiments of this application, "multiple" means two or more, unless explicitly and specifically limited otherwise.

Reference to "embodiment" herein means that a particular feature, structure, or characteristic described in connection with the embodiment may be included in at least one embodiment of this application. The appearance of this phrase in various places in the specification does not necessarily refer to the same embodiment, nor is it an independent or alternative embodiment mutually exclusive with other embodiments. Those skilled in the art explicitly and implicitly understand that the embodiments described herein can be combined with other embodiments.

In the description of the embodiments of this application, the term "and/or" merely describes an association relationship between associated objects, indicating that three relationships may exist, for example, A and/or B can mean: A exists alone, A and B exist simultaneously, and B exists alone. In addition, the character "/" herein generally indicates that the associated objects before and after are in an "or" relationship.

To facilitate understanding of this application, a brief introduction to related technologies is first provided.

In battery testing, EIS testing is a non-destructive technique for analyzing battery states. internal states such as SOC, SOH, internal temperature, and lithium precipitation of a battery can be analyzed by measuring the EIS of the battery and analyzing the impedance characteristics of the battery based on the EIS, so that the state of the battery can be relatively accurately determined.

During the EIS measurement process, a detection apparatus needs to input an excitation signal to the battery and acquire a voltage value and a current value of the battery under the action of the excitation signal, so that the EIS of the battery is determined based on the voltage value and current value.

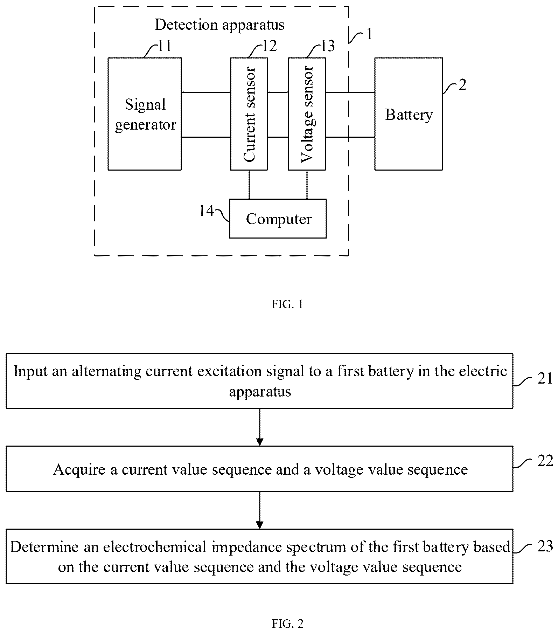

FIG. 1 is a schematic diagram of a scenario for measuring an electrochemical impedance spectrum according to an embodiment of this application. The detection apparatus 1 includes a signal generator 11, a current sensor 12, a voltage sensor 13, and a computer 14. During measurement of an EIS of a battery, the signal generator 11 generates an excitation signal and inputs the excitation signal to the battery 2. The voltage sensor 13 collects a voltage value of the battery 2 under the action of the excitation signal, and the current sensor 12 collects a current value of the excitation signal. The computer 14 determines the EIS of the battery 2 based on the voltage value and current value collected by the voltage sensor 13 and the current sensor 12.

As shown in FIG. 1, the detection apparatus 1 includes the signal generator 11, the current sensor 12, the voltage sensor 13, the computer 14, and the like, making it relatively complex and costly. Configuring a detection apparatus for an electric apparatus in practical use leads to increased costs of the electric apparatus. Moreover, the battery 2 is typically integrated inside the electric apparatus, and even if the detection apparatus 1 is configured for the electric apparatus, connecting the detection apparatus 1 to the battery 2 in the electric apparatus is relatively difficult. Therefore, the scheme of measuring an EIS of a battery through a detection apparatus is not have practical in actual applications.

The technical concept of the EIS measurement method according to the embodiments of this application is as follows: During use, an electric apparatus inevitably connects to a charging apparatus, a battery in the electric apparatus is charged through the charging apparatus. If the charging apparatus has the capability to output an excitation signal, after connected to the electric apparatus, the charging apparatus can input the excitation signal to the battery in the electric apparatus, thereby implementing EIS measurement of the battery in the electric apparatus.

Based on the above technical concept, the embodiments of this application provide an EIS measurement method and a charging apparatus. After connected to an electric apparatus, the charging apparatus can input an excitation signal to a battery in the electric apparatus, thereby measuring an EIS of the battery in the electric apparatus through the excitation signal output by the charging apparatus.

In the embodiments of this application, the charging apparatus inputs the excitation signal to the battery in the electric apparatus and determines the electrochemical impedance spectrum based on the excitation signal. During measurement of the electrochemical impedance spectrum of the battery, there is no need to configure a separate detection apparatus for the battery, thereby reducing the electrochemical impedance spectrum measurement cost. Additionally, the connection between the charging apparatus and the electric apparatus is a conventional connection, and the operation is relatively simple, so the EIS measurement method provided in the embodiments of this application is highly practical in actual applications.

FIG. 2 is a flowchart of an electrochemical impedance spectrum measurement method according to an embodiment of this application. As shown in FIG. 2, the method includes step 21, step 22, and step 23.

Step 21: Input an excitation signal to a first battery in an electric apparatus.

The excitation signal is used to measure an electrochemical impedance spectrum of the first battery. The excitation signal is, for example, an alternating current signal with a small amplitude such as 5 millivolts (mv), 4.7 mv, 4.8 mv, 5.1 mv, or 5.4 mv. A frequency of the excitation signal can fall between 0.01 Hertz (Hz) and 10 kilohertz (kHz). Furthermore, the excitation signal can include an excitation signal of one frequency or can be composed of excitation signals of multiple frequencies.

The excitation signal can be input to the first battery in the electric apparatus by a charging apparatus. The specific parameters of the excitation signal can be set according to needs, which are not restricted in this embodiment.

Step 22: Acquire a current value sequence and a voltage value sequence.

The current value sequence includes current values of the first battery during a process of inputting the excitation signal to the first battery, and the voltage value sequence includes voltage values of the first battery during the process of inputting the excitation signal to the first battery.

In this embodiment, during the process of inputting the excitation signal to the first battery in the electric apparatus, the current values of the first battery can be acquired to obtain the current value sequence, and the voltage values of the first battery can be acquired to obtain the voltage value sequence. For example, the current values and the voltage values of the first battery can be sampled by the charging apparatus to obtain the current value sequence and the voltage value sequence; or the current values and the voltage values of the first battery can be sampled by the electric apparatus to obtain the current value sequence and the voltage value sequence; or the current values the first battery can be sampled by one of the charging apparatus and the electric apparatus to obtain the current value sequence, and the voltage values the first battery can be sampled by the other to obtain the voltage value sequence.

Step 23: Determine the electrochemical impedance spectrum of the first battery based on the current value sequence and the voltage value sequence.

In this embodiment, after the current value sequence and the voltage value sequence are acquired, the electrochemical impedance spectrum of the first battery can be determined based on the current value sequence and the voltage value sequence.

To facilitate understanding of the electrochemical impedance spectrum measurement method according to the embodiments of this application, the following describes a charging apparatus according to an embodiment of this application.

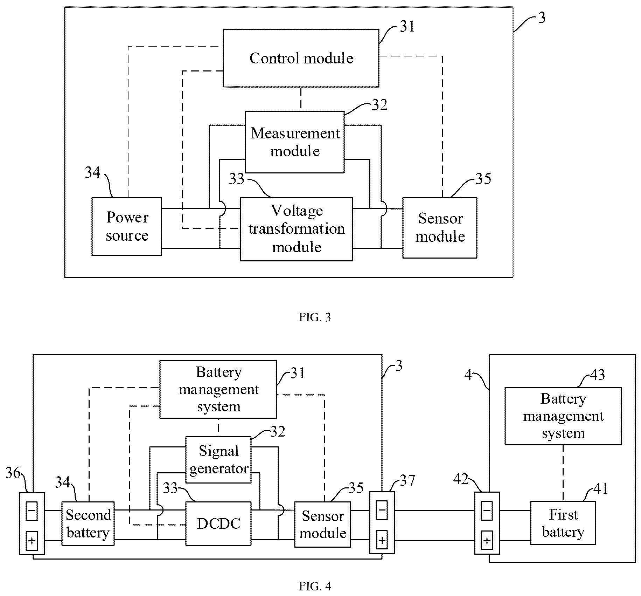

FIG. 3 is a schematic structural diagram of a charging apparatus according to an embodiment of this application. As shown in FIG. 3, the charging apparatus 3 includes a control module 31, a measurement module 32, and a voltage transformation module 33.

FIG. 4 is a schematic structural diagram of an electrochemical impedance spectrum measurement system according to an embodiment of this application. As shown in FIG. 4, the measurement system includes a charging apparatus 3 and an electric apparatus 4.

The control module 31 is separately connected to the measurement module 32 and the voltage transformation module 33. The measurement module 32 includes a signal generator, and the signal generator can be connected to the first battery 41 in the electric apparatus 4 and input an excitation signal to the first battery 41. An input terminal of the voltage transformation module 33 is connected to a power source 34, and an output terminal of the voltage transformation module 33 can be connected to the first battery 41. The voltage transformation module 33 can transform a voltage from the power source 34 to obtain and input a charging current to the first battery 41.

In one embodiment, the charging apparatus may be a mobile charging apparatus, such as an in-vehicle charging apparatus or another portable charging apparatus. When the charging apparatus is a mobile charging apparatus, the power source 34 can be a battery, and the battery serves as a power source to supply power to the charging apparatus 3. To distinguish it from the first battery 41 in the electric apparatus 4, the battery in the charging apparatus 3 can be named a second battery.

The second battery may include one or more battery modules, each battery module can be composed of multiple battery cells (the battery cells are also referred to as cells) connected in series and/or parallel. The specific implementation of the second battery can be set according to needs, and this embodiment does not impose restrictions thereto.

In another embodiment, the charging apparatus may be a stationary charging apparatus, such as a charging station. When the charging apparatus is a stationary charging apparatus, the power source 34 can be a power input port, the power input port can be connected to mains electricity to supply power to the charging apparatus 3 through the mains electricity.

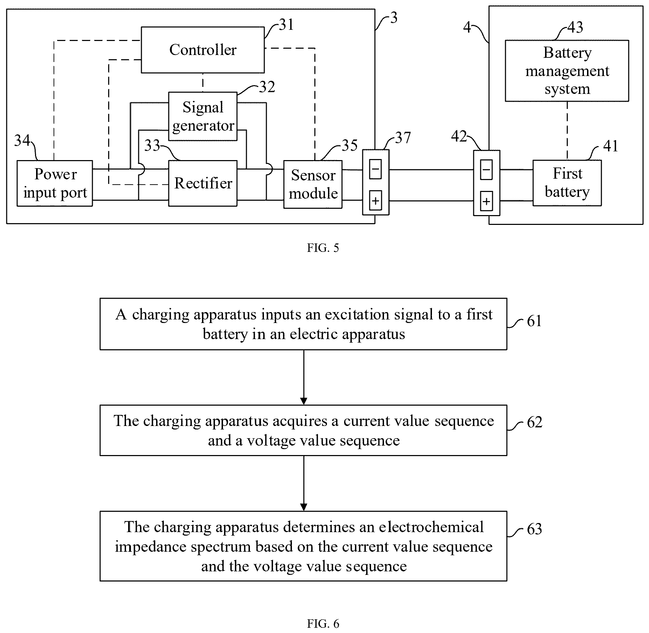

FIG. 5 is a schematic structural diagram of another electrochemical impedance spectrum measurement system according to an embodiment of this application. The charging apparatus 3 is a stationary charging apparatus, and the power source 34 is a power input port. The power input port can be any form of ports capable of connecting to mains electricity, and this embodiment does not impose restrictions thereto.

The above are only exemplary examples, and the power source in the charging apparatus may alternatively be other forms of power sources. For example, the power source may include a second battery and a power input port. This embodiment does not impose restrictions on the specific implementation of the power source in the charging apparatus.

In one embodiment, when the power source 34 is a second battery, the control module 31 can be a battery management system (battery management system, BMS), and the BMS can control the charging and discharging of the second battery.

As shown in FIG. 4, the charging apparatus 3 may further include a charging input interface 36, where the charging input interface 36 includes a negative electrode input terminal marked with a symbol "-" and a positive electrode input terminal marked with a symbol "+". The positive electrode input terminal of the charging input interface 36 is connected to a positive electrode of the second battery, and the negative electrode input terminal of the charging input interface 36 is connected to a negative electrode of the second battery.

During the use of the charging apparatus 3, when the power of the second battery is insufficient, the charging input interface 36 can be connected to an external power source, such as a charging station. The positive electrode input terminal of the charging input interface 36 is connected to a positive electrode of the charging station, and the negative electrode input terminal of the charging input interface 36 is connected to a negative electrode of the charging station. In this case, the control module 31 can control the second battery to enter a charging state, charging the second battery through the charging station.

In this embodiment, the voltage transformation module 33 is configured to transform an output voltage of the power source 34 to obtain and input a charging current to the first battery 41 to charge the first battery 41. As shown in FIG. 4, when the power source 34 is a second battery, the voltage transformation module 33 can be a direct current to direct current (Direct Current Direct Current, DCDC) converter. Input terminals of the voltage transformation module 33 are connected to two terminals of the second battery, for example, a positive electrode input terminal of the voltage transformation module 33 is connected to the positive electrode of the second battery, and a negative electrode input terminal of the voltage transformation module 33 is connected to the negative electrode of the second battery, thereby implementing an electrical connection between the voltage transformation module 33 and the second battery.

As shown in FIG. 4, the charging apparatus 3 further includes a charging output interface 37, where the charging output interface 37 includes a negative electrode output terminal marked with a symbol "-" and a positive electrode output terminal marked with a symbol "+". A positive electrode output terminal of the voltage transformation module 33 is connected to the positive electrode output terminal of the charging output interface 37, and a negative electrode output terminal of the voltage transformation module 33 is connected to the negative electrode output terminal of the charging output interface 37, thereby implementing an electrical connection between the charging output interface 37 and the voltage transformation module 33.

As shown in FIG. 4, the electric apparatus 4 includes a charging input interface 42, and the charging input interface 42 includes a negative electrode input terminal marked with a symbol "-" and a positive electrode input terminal marked with a symbol "+". The positive electrode input terminal of the charging input interface 42 is connected to a positive electrode of the first battery 41, and the negative electrode input terminal of the charging input interface 42 is connected to a negative electrode of the first battery 41.

When the charging output interface 37 is connected to the charging input interface 42, the positive electrode output terminal of the charging output interface 37 is connected to the positive electrode input terminal of the charging input interface 42, and the negative electrode output terminal of the charging output interface 37 is connected to the negative electrode input terminal of the charging input interface 42, so that the charging output interface 37 is electrically connected to the first battery 41, thereby enabling the voltage transformation module 33 to be electrically connected to the first battery 41.

After determining the electrical connection between the charging apparatus 3 and the electric apparatus 4, the control module 31 can send a second instruction to the voltage transformation module 33. Upon receiving of the second instruction, the voltage transformation module 33 starts operating, to transform the output voltage of the second battery to obtain a charging current. The charging current flows through the electrically connected charging output interface 37 and charging input interface 42, and then enters the first battery 41 to charge the first battery 41.

After determining that the charging of the first battery 41 is complete, the control module 31 can send a fourth instruction to the voltage transformation module 33. Upon receiving of the fourth instruction, the voltage transformation module 33 stops operating, to stop inputting the charging current to the first battery 41, thereby stopping the charging of the first battery 41.

As shown in FIG. 5, when the charging apparatus 3 is a stationary charging apparatus and the power source 34 is a power input port, the voltage transformation module 33 can be a rectifier. During the process of charging the first battery 41, the rectifier can rectify the mains electricity connected through the power input port to obtain and input a charging current to the first battery 41.

As shown in FIG. 4, the charging apparatus 3 further includes a sensor module 35. The sensor module 35 is connected to the control module 31, and the sensor module 35 can include a current sensor. During the process of inputting the charging current to the first battery 41, the current sensor can sample the current output to the charging output interface 37 to obtain a current value and output the current value to the control module 31. The control module 31 can control the voltage transformation module 33 based on the current value output by the current sensor, enabling the voltage transformation module 33 to output a stable charging current.

In one embodiment, the sensor module 35 may include a current sensor and a voltage sensor. The current sensor can sample the current output to the charging output interface 37 to obtain a current value, and the voltage sensor can sample a voltage between the positive electrode output terminal and negative electrode output terminal of the charging output interface 37 to obtain a voltage value.

Since the charging output interface 37 is connected to both terminals of the first battery 41 through the charging input interface 42, the current value sampled by the current sensor is a current values in a loop of the first battery 41, and the voltage value sampled by the voltage sensor is a voltage value across two terminals of the first battery 41.

The above are only exemplary examples, and the specific implementation methods of the control module, voltage transformation module, power source, and sensor module can be set according to needs, and this embodiment does not impose restrictions thereto.

In the embodiments of this application, the charging apparatus 3 includes a measurement module 32, where the measurement module 32 is configured to generate an excitation signal and input the excitation signal to the first battery 41.

As shown in FIG. 4, when the charging apparatus 3 is a mobile charging apparatus including a second battery, the signal generator can be an inverter, and the inverter is connected to both terminals of the second battery and configured to invert a direct current voltage output by the second battery to generate the excitation signal.

In this embodiment, when the signal generator is an inverter, the implementation of the inverter is relatively simple, which can reduce the development difficulty of the charging apparatus. Additionally, the inverter technology is relatively mature, improving the stability during the EIS measurement process.

A positive electrode input terminal of the inverter is connected to the positive electrode of the second battery, and a negative electrode input terminal of the inverter is connected to the negative electrode of the second battery, thereby implementing an electrical connection between the inverter and the second battery.

Additionally, the positive electrode output terminal of the inverter is connected to the positive electrode output terminal of the charging output interface 37, and the negative electrode output terminal of the inverter is connected to the negative electrode output terminal of the charging output interface 37, thereby implementing an electrical connection between the inverter and the charging output interface 37.

As shown in FIG. 4, when the charging output interface 37 is connected to the charging input interface 42, the signal generator is indirectly connected to the first battery 41 through the interconnected charging output interface 37 and charging input interface 42. During the operation of the charging apparatus 3, the control module 31 can send a first instruction to the signal generator. Upon receiving of the first instruction, the signal generator starts operating in response to the first instruction, to invert the output voltage of the second battery to generate an excitation signal. The excitation signal is input to the second battery through the charging output interface 37 and the charging input interface 42.

As shown in FIG. 5, when the charging apparatus 3 is a stationary charging apparatus and the power source 34 is a power input port, the signal generator can be an alternating current transformer. The alternating current transformer is connected to the power input port. Upon receiving of the first instruction, the alternating current transformer starts operating, to transform the mains electricity connected through the power input port to obtain and input an excitation signal to the first battery 41.

At the end of the measurement, the control module 31 can send a third instruction to the measurement module 32. Upon receiving of the third instruction, the measurement module 32 stops outputting the excitation signal to stop measuring the EIS of the first battery 41.

In one embodiment, the charging apparatus can acquire the current value sequence and the voltage value sequence of the first battery and determine the electrochemical impedance spectrum based on the current value sequence and the voltage value sequence.

In this embodiment, when the signal generator is an alternating current transformer, the implementation of the alternating current transformer is relatively simple, which can reduce the development difficulty of the charging apparatus. Additionally, the alternating current transformer technology is relatively mature, improving the stability during the EIS measurement process.

This embodiment provides a measurement system including an electric apparatus and a charging apparatus. The charging apparatus is configured to input an excitation signal to a first battery in the electric apparatus, where the excitation signal is used to measure an electrochemical impedance spectrum of the first battery. The charging apparatus is further configured to determine the electrochemical impedance spectrum based on a current value sequence and a voltage value sequence.

FIG. 6 is a flowchart of an electrochemical impedance spectrum measurement method according to an embodiment of this application. This method can be performed by a charging apparatus, for example, can be performed by a control module 31 in the charging apparatus 3. As shown in FIG. 6, the method may include steps 61 to 63.

Step 61: The charging apparatus inputs an excitation signal to a first battery in an electric apparatus.

In one embodiment, after establishing an electrical connection to the first battery 41, the charging apparatus 3 can input an excitation signal to the first battery 41 when a preset first trigger condition is met, so as to measure an electrochemical impedance spectrum of the first battery 41 through the excitation signal. After inputting the excitation signal to the first battery 41, the charging apparatus 3 can stop inputting the excitation signal to the first battery 41 when a preset second trigger condition is met, so as to stop measuring the electrochemical impedance spectrum of the first battery 41.

The first trigger condition and the second trigger condition can be specifically set according to needs, and this embodiment does not impose restrictions thereto.

Step 62: The charging apparatus acquires a current value sequence and a voltage value sequence.

In one embodiment, the charging apparatus 3 can sample a current in a loop of the first battery 41 to obtain the current value sequence, and sample a voltage across two terminals of the first battery 41 to obtain the voltage value sequence.

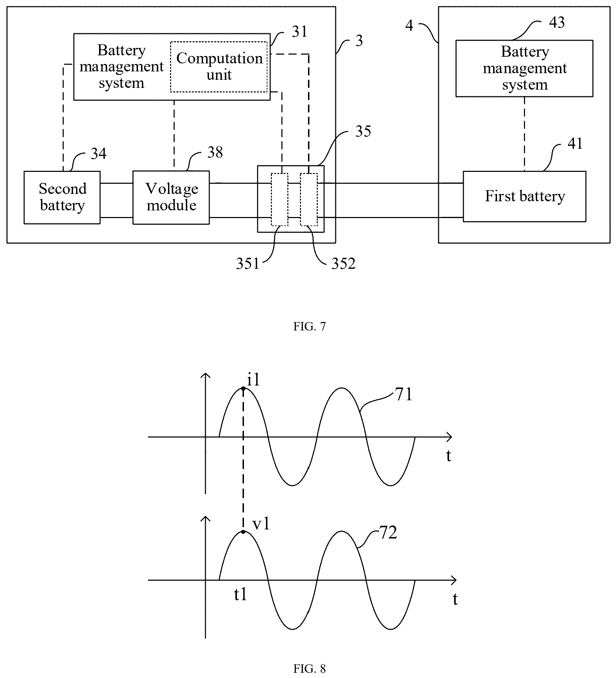

FIG. 7 is a schematic structural diagram of still another electrochemical impedance spectrum measurement system according to an embodiment of this application. In the charging apparatus 3 shown in FIG. 7, a voltage module 38 includes the measurement module 32 and the voltage transformation module 33 shown in FIG. 3 and FIG. 4. The sensor module 35 includes a current sensor 351 and a voltage sensor 352, where the current sensor 351 and the voltage sensor 352 are both communicatively connected to the control module 31.

The current sensor 351 samples the current output to the charging output interface 37 at a preset sampling frequency. After sending a first instruction to the measurement module 32 in the voltage module 38 to cause the measurement module 32 to input an excitation signal to the first battery 41, the control module 31 can acquire the current value sampled by the current sensor 351 at each sampling time point, thereby obtaining a current value sequence composed of multiple current values sampled continuously.

Similarly, the voltage sensor 352 samples the voltage across two terminals of the charging output interface 37 at a preset sampling frequency. After sending a first instruction to the measurement module 32 to cause the measurement module 32 to input an excitation signal to the first battery 41, the control module 31 can acquire the voltage value sampled by the voltage sensor 352 at each sampling time point, thereby obtaining a voltage value sequence composed of multiple voltage values sampled continuously.

The sampling frequency of the voltage sensor 352 can be the same as the sampling frequency of the current sensor 351, and the sampling frequency of the voltage sensor 352 and the sampling frequency of the current sensor 351 are greater than a frequency of the excitation signal. For example, when the frequency of the excitation signal is M, the sampling frequency of the current sensor 351 and the sampling frequency of the voltage sensor 352 can be no less than 5 times M.

In practical applications, when the sampling frequency of the current sensor 351 and the sampling frequency of the voltage sensor 352 are greater than the frequency of the excitation signal and not less than 5 times the frequency of the excitation signal, the sampled current values and voltage values can more accurately characterize the voltage transformation and current change of the first battery under the action of the excitation signal, thereby making the obtained electrochemical impedance spectrum more accurate.

As shown in FIG. 3 and FIG. 4, the current value sampled by the current sensor 351 is a current value input to the first battery 41 through the charging output interface 37, so the current value sampled by the current sensor 351 is a current value of the current in the loop of the first battery 41.

Similarly, the voltage value sampled by the voltage sensor 352 is the voltage value across two ends of the charging output interface 37. Since both terminals of the first battery 41 are connected to the charging output interface 37 through the charging input interface 42, the voltage value sampled by the voltage sensor 352 is the voltage value across two terminals of the first battery 41.

The two ends of the charging output interface 37 are the positive electrode output terminal and the negative electrode output terminal of the charging output interface 37, the two terminals of the first battery 41 are the positive electrode and the negative electrode of the first battery 41, and the loop of the first battery 41 is a charging loop.

Step 63: The charging apparatus determines an electrochemical impedance spectrum based on the current value sequence and the voltage value sequence.

When the charging apparatus 3 inputs the excitation signal to the first battery 41 before or after inputting the charging current to the first battery 41, only the excitation signal is input to the first battery 41. In this case, the current value sampled by the current sensor 351 is the current value of the excitation signal, and the voltage value sampled by the voltage sensor 352 is the voltage value of the first battery 41 under the action of the excitation signal.

In this embodiment, when the charging apparatus 3 inputs the excitation signal to the first battery 41 before or after inputting the charging current to the first battery 41, the charging apparatus 3 can directly determine the EIS of the first battery based on the current value sequence and the voltage value sequence.

As shown in FIG. 7, the control module 31 may include a computation unit, where the computation unit is configured to determine the EIS of the first battery 41 based on the current value sequence and the voltage value sequence. The computation unit can be implemented by a software module and/or a hardware module in the control module 31, and this embodiment does not impose restrictions thereto.

FIG. 8 is a schematic diagram of signal changes according to an embodiment of this application. In FIG. 8, a horizontal axis represents time, and a vertical axis represents amplitude. A curve 71 is a partial current change curve of the excitation signal, composed of multiple current values of the excitation signal over a period of time. A curve 72 is composed of multiple voltage values across two terminals of the first battery 41 over a period of time, and the curve 72 is a curve representing voltage changes across the two terminals of the first battery 41 under the action of the excitation signal.

When determining the EIS of the first battery 41, the charging apparatus 3 can select the voltage value and current value sampled at the same sampling time point from the current value sequence and the voltage value sequence, calculate a ratio between the voltage value and current value sampled at the same sampling time point to obtain an impedance value, thereby obtaining an EIS of the first battery composed of a series of impedance values.

For example, the current values in the current value sequence are i(n), the voltage values in the voltage value sequence are v(n), n is a count value of sampling periods, and the sampling period can be determined based on the sampling frequency. After the current value sequence and the voltage value sequence is obtained, a Fourier transform can be performed on the current values i(n) in the current value sequence to obtain Fi(f), and a Fourier transform can be performed on the voltage values v(n) in the voltage value sequence to obtain Fi(f). The impedance of the first battery 41 is expressed as Z(f), and the impedance calculation formula is:

$$Z(f) = \frac{Fu(f)}{Fi(f)}$$

For example, the current value i1 and the voltage value v1 shown in FIG. 8 are the current value and voltage value sampled by the current sensor 351 and the voltage sensor 352 at the same sampling time point t1. The control module 31 can calculate the ratio of the voltage value v1 to the current value i1 to obtain the impedance value corresponding to the sampling time point t1. Similarly, the ratio of the voltage value to the current value sampled at each sampling time point can be calculated, thereby obtaining an EIS of the first battery composed of a series of impedance values.

When the charging apparatus 3 inputs the excitation signal to the first battery 41 while inputting the charging current to the first battery 41, the current input to the first battery 41 includes both the excitation signal and the charging current. In this case, the current values sampled by the current sensor 351 include not only the alternating current component corresponding to the excitation signal but also the direct current component corresponding to the charging current. The voltage values sampled by the voltage sensor 352 include not only the alternating voltage component corresponding to the excitation signal but also the direct voltage component corresponding to the charging current.

In this embodiment, when the charging apparatus 3 inputs the excitation signal to the first battery 41 while inputting the charging current to the first battery 41, the charging apparatus 3 can extract the alternating voltage component corresponding to the excitation signal from the voltage value sequence and extract the alternating current component corresponding to the excitation signal from the current value sequence. For example, the voltage value sequence shown by the curve 72 (this voltage value sequence being the alternating voltage component) can be extracted from the voltage value sequence, and the current value sequence shown by the curve 71 (this current value sequence being the alternating current component) can be extracted from the current value sequence, and then the EIS of the first battery can be determined based on the extracted alternating voltage component and alternating current component.

The above are only exemplary examples, and the specific methods for determining the EIS of the first battery based on the voltage value sequence and the current value sequence can include but are not limited to the above examples, and this embodiment does not impose restrictions thereto.

In the embodiments of this application, when the voltage value sequence and the current value sequence of the first battery are obtained through sampling by the electric apparatus, the electric apparatus does not need to send the voltage value sequence and the current value sequence to the charging apparatus during the charging process, simplifying the interaction process between the electric apparatus and the charging apparatus.

The above are only exemplary examples, and the methods for the charging apparatus to acquire the voltage value sequence and the current value sequence can include but are not limited to the above examples.

In the embodiments of this application, during the process of inputting the excitation signal to the electric apparatus, the charging apparatus acquires the voltage value sequence and the current value sequence of the first battery under the action of the excitation signal and determines the EIS of the first battery based on the voltage value sequence and the current value sequence, facilitating the charging apparatus in promptly obtaining the EIS of the first battery when connected to the electric apparatus, allowing for a timely response when an abnormality in the first battery is detected based on the EIS of the first battery.

Optionally, before the inputting an excitation signal to a first battery, the method may further include: inputting a first identification signal to the first battery, where the first identification signal is used to identify the start of inputting the excitation signal to the first battery.

In one embodiment, before inputting the excitation signal to the first battery, the charging apparatus may further input a first identification signal to the first battery. The first identification signal may be the same as or different from the excitation signal. The first identification signal is used to identify the start of inputting the excitation signal to the first battery, that is, the start of measuring the EIS of the first battery, so as to determine, from the voltage values and current values corresponding to the first identification signal, the current value and voltage value that are at the same sampling time point and correspond to the excitation signal, thereby aligning the voltage value and current value corresponding to the excitation signal.

For example, after receiving the first instruction, the measurement module 32 first generates the first identification signal and inputs the first identification signal to the first battery 41, then generates the excitation signal, and inputs the excitation signal to the first battery 41. An interval between the first identification signal and the excitation signal may be set to 0.

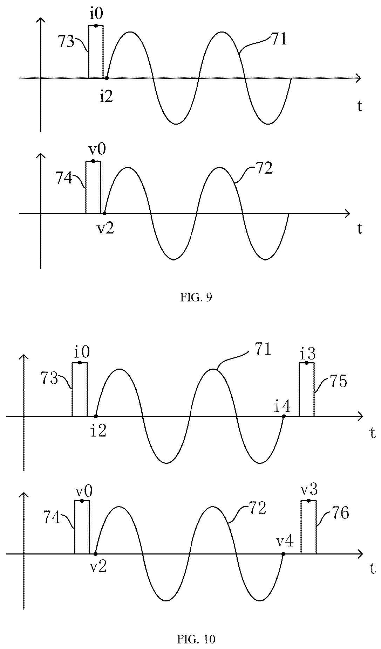

FIG. 9 is another schematic diagram of signal changes according to an embodiment of this application. The first identification signal is a single-pulse signal, a curve 73 is a current curve corresponding to the first identification signal, and a curve 74 is a voltage curve corresponding to the first identification signal.

When the charging apparatus 3 inputs the first identification signal to the first battery 41, the current sensor 351 can perform sampling to obtain the current value corresponding to the first identification signal, such as the current value i0 shown in FIG. 9. Similarly, the voltage sensor 352 can perform sampling to obtain the voltage value corresponding to the first identification signal, such as the voltage value v0 shown in FIG. 9.

Optionally, during the process of determining the electrochemical impedance spectrum of the first battery based on the current value sequence and the voltage value sequence, if the voltage value sequence includes a voltage value corresponding to an identification signal, a voltage value subsequence corresponding to the excitation signal can be determined from the voltage value sequence. Similarly, if the current value sequence includes a current value corresponding to an identification signal, a current value subsequence corresponding to the excitation signal can be determined from the current value sequence. Then, the electrochemical impedance spectrum can be determined based on the voltage value subsequence and the current value subsequence.

For ease of distinction, in this embodiment, the current value corresponding to the first identification signal is referred to as a first current value, the voltage value corresponding to the first identification signal is referred to as a first voltage value, the current value corresponding to the excitation signal is referred to as a second current value, and the voltage value corresponding to the excitation signal is referred to as a second voltage value.

The charging apparatus 3 can determine, based on the first current values corresponding to the first identification signal, a starting position of the second current values corresponding to the excitation signal in the current value sequence from the current value sequence sampled by the current sensor 351, and determine all second current values based on the starting position, thereby obtaining a current value subsequence composed of multiple second current values.

Similarly, the charging apparatus 3 can determine, based on the first voltage values corresponding to the first identification signal, a starting position of the second voltage values corresponding to the excitation signal in the voltage value sequence from the voltage value sequence sampled by the voltage sensor 352, and determine all second voltage values based on the starting position, thereby obtaining a voltage value subsequence composed of multiple second voltage values.

As shown in FIG. 9, after outputting the first identification signal, the measurement module 32 then outputs the excitation signal, causing the current value sequence to first contain the first current values corresponding to the first identification signal, followed by the second current values corresponding to the excitation signal.

For example, the first identification signal is a single-pulse signal with a constant amplitude, so the current sensor 351 can collect multiple consecutive current values all being i0. In the entire current value sequence, the second current value i2 that appears after multiple consecutive identical first current values i0 is the 1st second current value among all second current values corresponding to the excitation signal, and the current values following the second current value i2 are other second current values corresponding to the excitation signal. Therefore, the position of the second current value i2 in the current value sequence is the starting position of all second current values corresponding to the excitation signal in the current value sequence, and the multiple second current values following the second current value i2 form the current value subsequence corresponding to the excitation signal.

Similarly, when the measurement module 32 outputs the first identification signal followed by the excitation signal, the voltage sensor 352 can collect multiple consecutive voltage values v0. In the entire voltage value sequence sampled by the voltage sensor 352, the second voltage value v2 that appears after multiple consecutive identical first voltage values v0 is the 1st second voltage value among all second voltage values corresponding to the excitation signal, and the voltage values following the second voltage value v2 are other second voltage values corresponding to the excitation signal. Therefore, the position of the second voltage value v2 in the voltage value sequence is the starting position of all second voltage values corresponding to the excitation signal in the voltage value sequence, and the multiple second voltage values following the second voltage value v2 form the voltage value subsequence corresponding to the excitation signal.

It should be noted that the current sensor 351 performs sampling at a fixed sampling frequency, so there is a time interval between the adjacent first current value i0 and second current value i2. Similarly, the voltage sensor 352 performs sampling at a fixed sampling frequency, so there is a time interval between the adjacent first voltage value v0 and second voltage value v2.

In this embodiment, during the process of determining the impedance of the first battery, the charging apparatus can determine that the first current value in the current value subsequence and the first voltage value in the voltage value subsequence are the current value and voltage value at the same sampling time point, and determine that the second current value in the current value subsequence and the second voltage value in the voltage value subsequence are the current value and voltage value at the same sampling time point. Following this pattern, the second voltage value and second current value at each sampling time point can be determined, achieving the alignment of the second voltage values with the second current values.

Then, the charging apparatus can calculate the ratio between the second voltage value and second current value corresponding to each sampling time point, to obtain the impedance value corresponding to each sampling time point, resulting in an EIS of the first battery 41 composed of a series of impedance values.

In practical applications, the current sensor and voltage sensor perform sampling at preset sampling frequencies, to obtain a series of current values and voltage values. Since it is difficult to synchronize the start time of sampling by the current sensor and voltage sensor with the start time of inputting the excitation signal to the first battery, the current sensor and voltage sensor may sample the voltage value and current value obtained before the excitation signal is input to the first battery.

Moreover, it is also difficult to synchronize the start time of sampling by the current sensor and voltage sensor, so when directly determining the voltage value and current value corresponding to the same sampling time point based on the positions of the current values in the current value sequence and the positions of the voltage values in the voltage value sequence, the determined pair of voltage value and current value may not be the voltage value and current value at the same sampling time point.

For example, the 1st current value in the current value sequence may be the current value at sampling time point t1, while the 1st voltage value in the voltage value sequence may be the voltage value at sampling time point t2, and they are not the current value and voltage value at the same sampling time point. If the 1st current value in the current value sequence and the 1st voltage value in the voltage value sequence are directly used as the voltage value and current value at the same time point to calculate the impedance, the calculated impedance is incorrect.

In the embodiments of this application, when determining the EIS of the first battery, the charging apparatus can determine, from the current value sequence and the voltage value sequence based on the voltage value and current value corresponding to the first identification signal, the current value and voltage value that are at a same sampling time point and correspond to the excitation signal, implementing alignment of the voltage value and current value corresponding to the excitation signal. The impedance of the battery is determined based on the aligned voltage value and current value, so that a more accurate impedance can be calculated, thereby obtaining a more accurate electrochemical impedance spectrum.

In one embodiment, the charging apparatus 3 can output the excitation signal after a preset first interval duration following the output of the first identification signal. At this time, in the entire current value sequence sampled by the current sensor 351, the current value that is separated from the last first current value i0 by the first interval duration after multiple consecutive identical first current values i0 is the first one among all second current values corresponding to the excitation signal. The first interval duration can be set according to needs, and this embodiment does not impose restrictions thereto.

Similarly, when the charging apparatus 3 outputs the excitation signal after a first interval duration following the output of the first identification signal, in the entire voltage value sequence sampled by the voltage sensor 352, the voltage value that is separated from the last first voltage value v0 by the first interval duration after multiple consecutive identical first voltage values v0 is the first one among all second voltage values corresponding to the excitation signal.

Optionally, after the inputting an excitation signal to a first battery, the method may further include: inputting a second identification signal to the first battery, where the second identification signal is used to identify the stop of inputting the excitation signal to the first battery.

In one embodiment, after inputting the excitation signal to the first battery, the charging apparatus may further input a second identification signal to the first battery. The second identification signal may be the same as or different from the excitation signal. The second identification signal is used to identify the stop of inputting the excitation signal to the first battery, that is, to identify the stop of measuring the EIS of the first battery, so as to remove the voltage value and current value unrelated to the excitation signal from the current value sequence and the voltage value sequence based on the second identification signal.

After receiving the third instruction, the measurement module 32 can first stop inputting the excitation signal to the first battery 41, then generate the second identification signal, and input the second identification signal to the first battery 41. An interval duration between the excitation signal and the second identification signal may be set to 0.

FIG. 10 is still another schematic diagram of signal changes according to an embodiment of this application. The second identification signal is a single-pulse signal, the curve 75 shown in FIG. 10 is the current curve corresponding to the second identification signal, and the curve 76 is the voltage curve corresponding to the second identification signal.

When the charging apparatus 3 inputs the second identification signal to the first battery 41, the current sensor 351 can perform sampling to obtain the current value corresponding to the second identification signal, such as the current value i3 shown in FIG. 10. Similarly, the voltage sensor 352 can perform sampling to obtain the voltage value corresponding to the second identification signal, such as the voltage value v3 shown in FIG. 10.

For ease of distinction, the current value corresponding to the second identification signal can be referred to as a third current value, and the voltage value corresponding to the second identification signal can be referred to as a third voltage value.

In this embodiment, the second identification signal is input to the first battery 41 after the excitation signal stops, and the charging apparatus 3 can determine an ending position of the second current values corresponding to the excitation signal in the entire current value sequence based on the third current values corresponding to the second identification signal from the entire current value sequence sampled by the current sensor 351.

Similarly, the charging apparatus 3 can determine an ending position of the second voltage values corresponding to the excitation signal in the entire voltage value sequence sampled by the voltage sensor 352 based on the third voltage values corresponding to the second identification signal.

As shown in FIG. 10, in the entire current value sequence sampled by the current sensor 351, the second current value i4 that appears before multiple consecutive identical third current values i3 is the last second current value among all second current values corresponding to the excitation signal, and the position of the second current value i4 in the entire current value sequence is the ending position of the current value subsequence corresponding to the excitation signal in the entire current value sequence, with the multiple current values before the ending position being second current values.

Similarly, in the entire voltage value sequence sampled by the voltage sensor 352, the second voltage value v4 that appears before multiple consecutive identical third voltage values v3 is the last second voltage value among all voltage values corresponding to the excitation signal, and the position of the second voltage value v4 in the entire voltage value sequence is the ending position of the voltage value sequence corresponding to the excitation signal in the entire voltage value sequence, with the multiple voltage values before the ending position being second voltage values.

In this embodiment, when the charging apparatus inputs the second identification signal to the first battery after inputting the excitation signal to the first battery, the charging apparatus 3, when calculating the EIS of the first battery, first determines the third current values from the current value sequence, and removes the third current values and other current values following the third current values, to obtain the current value subsequence. Similarly, the third voltage values can be removed from the voltage value sequence, and other voltage values following the third voltage values can be removed, to obtain the voltage value subsequence.

As shown in FIG. 10, during the process of calculating the EIS of the first battery, the charging apparatus 3 can determine multiple consecutive third current values i3 from the current value sequence, remove the third current values i3 and other current values following the third current values i3 from the current value sequence, as well as remove the first current values i0 and the current values before the first current values i0, to obtain a current value subsequence composed of multiple consecutive second current values.

Similarly, multiple consecutive third voltage values v3 can be determined from the voltage value sequence, and the third voltage values v3 and other voltage values following the third voltage values v3 can be removed from the voltage value sequence, as well as the first voltage values v0 and the voltage values before the first voltage values v0, to obtain a voltage value subsequence composed of multiple consecutive second voltage values.

In practical applications, the current sensor may sample current values obtained after the excitation signal has stopped, and the voltage sensor may sample voltage values obtained after the excitation signal has stopped. If the impedance of the first battery is calculated based on the voltage values and current values after input of the excitation signal has stopped, the calculated impedance is unrelated to the first battery, causing the EIS of the first battery to include content unrelated to the first battery.

In the embodiments of this application, after inputting the excitation signal to the first battery, the charging apparatus inputs the second identification signal to the first battery. In determining the EIS of the first battery, voltage values unrelated to the excitation signal can be removed from the voltage value sequence based on the voltage values corresponding to the second identification signal, and current values unrelated to the excitation signal can be removed from the current value sequence based on the current values corresponding to the second identification signal, improving the accuracy of the current values and voltage values corresponding to the excitation signal, thereby obtaining a more accurate electrochemical impedance spectrum.

The above are only exemplary examples, and the specific methods for extracting the current value subsequence corresponding to the excitation signal from the current value sequence and extracting the voltage value subsequence corresponding to the excitation signal from the voltage value sequence can include but are not limited to the above examples.

In the implementation of this application, during the process of determining the electrochemical impedance spectrum based on the current value sequence and the voltage value sequence, the voltage value subsequence corresponding to the excitation signal is extracted from the voltage value sequence, and the current value subsequence corresponding to the excitation signal is extracted from the current value sequence. Since the current value subsequence and the voltage value subsequence are the voltage values and current values of the battery under the action of the excitation signal, determining the electrochemical impedance spectrum based on the current value subsequence and the voltage value subsequence can avoid introducing other voltage values and current values, thereby improving the accuracy of the electrochemical impedance spectrum.

In one embodiment, the charging apparatus 3 can output the second identification signal after a preset second interval duration following the output of the excitation signal. At this time, in the current value sequence sampled by the current sensor 351, there is a second interval duration between the adjacent second current value and third current value.

Similarly, when the charging apparatus 3 outputs the second identification signal after a second interval duration following the output of the excitation signal, in the voltage value sequence sampled by the voltage sensor 352, there is a second interval duration between the adjacent second voltage value and third voltage value.

In determining the EIS of the first battery based on the current value sequence and the voltage value sequence, all third voltage values in the voltage value sequence can be removed, and the voltage values within the second interval duration before the third voltage values can be removed, so as to obtain the voltage value subsequence. Similarly, all third current values in the current value sequence can be removed, and the current values within the second interval duration before the third voltage values can be removed, so as to obtain the current value subsequence.

Optionally, the duration of the identification signal input by the charging apparatus to the first battery is greater than or equal to a preset number of sampling periods of the excitation signal, with the preset number being, for example, 3.

The identification signal includes the first identification signal and the second identification signal mentioned in the above examples. The sampling period of the excitation signal is the sampling period of the current sensor and the voltage sensor mentioned in the above examples. The current sensor and the voltage sensor are used to sample the voltage and current of the first battery under the action of the excitation signal, respectively, and the sampling periods of the current sensor and the voltage sensor are the sampling periods of the excitation signal.

For example, when the sampling period of the current sensor is T, the duration of the first identification signal and the second identification signal is greater than or equal to 3T, such as 3T, 3.5T, 4T, 4.5T, or 5T. As shown in FIG. 10, when the sampling period of the first identification signal and the second identification signal is not less than 3T, the number of sampled first voltage values $v0$ and first current values $i0$ is not less than the number within 3 sampling periods. Similarly, the number of sampled third voltage values $v3$ and third current values $i3$ is not less than the number within 3 sampling periods.

It can be understood that the specific value of the preset number can be set according to needs, and this embodiment does not impose restrictions thereto. The duration of the first identification signal and the second identification signal can be set according to needs, and this embodiment does not impose restrictions thereto.

In the embodiments of this application, the duration of the identification signal input by the charging apparatus to the first battery is not less than the preset number of sampling periods of the excitation signal. In sampling the voltage and current corresponding to the excitation signal, the sampled current value sequence and voltage value sequence can include a larger number of voltage and current values corresponding to the identification signal, allowing for more accurate differentiation between the voltage values and current values corresponding to the identification signal and the excitation signal from the current value sequence and the voltage value sequence.

Optionally, the identification signal input by the charging apparatus to the first battery includes any one of a single-pulse signal, a multi-pulse signal, a step signal, a triangular wave signal, and a trapezoidal wave signal.

For example, the first identification signal and the second identification signal can be single-pulse signals as shown in FIG. 9 and FIG. 10, or any one of a multi-pulse signal, a step signal, a triangular wave signal, and a trapezoidal wave signal, or other forms of identification signals. This embodiment does not impose restrictions on the specific form of the first identification signal and the second identification signal.

In the embodiments of this application, the voltage values and current values corresponding to identification signals such as single-pulse signals, multi-pulse signals, step signals, triangular wave signals, and trapezoidal wave signals are easily recognizable. Therefore, when the first identification signal and the second identification signal are one of the above signals, in the case of extracting the voltage value subsequence and the current value subsequence from the voltage value sequence and the current value sequence, it is easy to distinguish between the voltage values corresponding to the identification signal and the voltage values corresponding to the excitation signal, as well as distinguish between the current values corresponding to the identification signal and the current values corresponding to the excitation signal. This facilitates accurate extraction of the voltage value subsequence from the voltage value sequence and the current value subsequence from the current value sequence.

Optionally, the step of inputting an excitation signal to a first battery in an electric apparatus includes: inputting the excitation signal to the first battery at preset intervals; or inputting the excitation signal to the first battery in a case that a state of charge of the first battery reaches a preset threshold.

In one embodiment, after establishing an electrical connection to the first battery 41 in the electric apparatus 4, the charging apparatus 3 can input the excitation signal to the first battery 41 while inputting the charging current to the first battery 41, so as to measure the electrochemical impedance spectrum of the first battery 41 during the charging process of the first battery 41.

For example, a first trigger condition can be set as the voltage transformation module 33 starting to input the charging current to the first battery. As shown in FIG. 4, after sending the second instruction to the voltage transformation module 33, the control module 31 determines that the first trigger condition is met and can send the first instruction to the measurement module 32. Upon receiving of the first instruction, the measurement module 32 starts operating, to input the excitation signal to the first battery 41, and begin measuring the EIS of the first battery 41.

For example, the second trigger condition can be set as the voltage transformation module 33 stopping inputting the charging current to the first battery. As shown in FIG. 4, after sending the fourth instruction to the voltage transformation module 33, the control module 31 determines that the second trigger condition is met and can send the third instruction to the measurement module 32. Upon receiving of the third instruction, the measurement module 32 stops operating, to stop the input of the excitation signal to the first battery 41, and stop measuring the EIS of the first battery 41.

The above are only exemplary examples, and after connecting to the first battery 41 in the electric apparatus 4, the charging apparatus 3 can input the excitation signal to the first battery 41 at any time point to measure the EIS of the first battery 41 based on the excitation signal.

In some embodiments, if the charging apparatus outputs the excitation signal while inputting the charging current to the first battery, the charging apparatus can input the excitation signal to the first battery once at preset intervals. Duration of each excitation signal output can be set according to needs.

For example, the preset duration is T1, and the duration of the excitation signal is T2. After sending the second instruction to the voltage transformation module 33, the control module 31 determines that the first trigger condition is met, sends the first instruction to the measurement module 32, and starts timing. Upon receiving of the first instruction, the measurement module 32 begins inputting the excitation signal to the first battery 41.

When the timed duration reaches T2, the control module 31 sends the third instruction to the measurement module 32 and restarts timing. Upon receiving of the third instruction, the measurement module 32 stops inputting the excitation signal to the first battery 41. When the timed duration reaches T1, the control module 31 sends the first instruction to the measurement module 32 again, causing the measurement module 32 to input the excitation signal to the first battery 41 again and restart timing. This process can be repeated to input the excitation signal to the first battery once at preset intervals.

Similarly, each time the first instruction is received, the measurement module 32 can first input the first identification signal to the first battery and then input the excitation signal to the first battery. Similarly, each time the third instruction is received, the measurement module 32 can first stop inputting the excitation signal to the first battery and then input the second identification signal to the first battery.

In some embodiments, if the charging apparatus outputs the excitation signal while inputting the charging current to the first battery, the charging apparatus can input the excitation signal to the first battery in a case that a state of charge of the first battery reaches a preset threshold.

For example, during the process of the charging apparatus 3 inputting the charging current to the first battery 41, the control module 31 can communicate with the battery management system 43 in the electric apparatus to acquire the state of charge of the first battery 41. When the state of charge of the first battery 41 reaches the preset threshold, the control module 31 sends the first instruction to the measurement module 32, and upon receiving of the first instruction, the measurement module 32 begins inputting the excitation signal to the first battery.

In the embodiments of this application, when measuring the electrochemical impedance spectrum of the first battery, the charging apparatus can input the excitation signal to the first battery once at preset intervals or in a case that a state of charge of the first battery reaches a preset threshold, reducing the duration of measuring the EIS of the first battery, thereby reducing the power consumption of the charging apparatus.

In some embodiments, after establishing an electrical connection to the first battery in the electric apparatus, the charging apparatus can input the excitation signal to the first battery before starting to charge the first battery, so as to measure the electrochemical impedance spectrum of the first battery before starting to charge the first battery.

For example, the first trigger condition can be set as the charging apparatus establishing an electrical connection to the first battery. As shown in FIG. 4, when the control module 31 detects that the charging output interface 37 is electrically connected to the charging input interface 42, it determines that the charging apparatus 3 has established an electrical connection with the first battery 41, meeting the first trigger condition. At this time, the control module 31 can send the first instruction to the measurement module 32, and upon receiving of the first instruction, the measurement module 32 starts operating, to input the excitation signal to the first battery 41.

For example, the second trigger condition can be set as the measurement duration. The control module 31 starts timing upon sending of the first instruction to the measurement module 32, and when the timed duration reaches the measurement duration, it determines that the second trigger condition is met. At this time, the control module 31 can send the third instruction to the measurement module 32, and upon receiving of the third instruction, the measurement module 32 stops inputting the excitation signal to the first battery 41. The measurement duration can be set according to needs, and this embodiment does not impose restrictions thereto.

When measuring the electrochemical impedance spectrum of the first battery 41 before charging the first battery 41, the control module 31 can send the second instruction to the voltage transformation module 33 after sending the third instruction to the measurement module 32. Upon receiving of the second instruction, the voltage transformation module 33 starts operating, to input the charging current to the first battery 41, and begin charging the first battery 41.

In another embodiment, the charging apparatus 3 can input the excitation signal to the first battery 41 after completing the charging of the first battery 41, to measure the electrochemical impedance spectrum of the first battery 41 after stopping charging.

For example, the first trigger condition can be set as the output of the charging current having been stopped. As shown in FIG. 4, after detecting that the charging output interface 37 is electrically connected to the charging input interface 42, the control module 31 first sends the second instruction to the voltage transformation module 33. Upon receiving of the second instruction, the voltage transformation module 33 starts operating, to input the charging current to the first battery 41, and begin charging the first battery.

During the charging process, the control module 31 communicates with the battery management system 43 in the electric apparatus 4 to determine whether the first battery 41 is fully charged. Upon determining that the first battery 41 is fully charged, the control module 31 sends the fourth instruction to the voltage transformation module 33. Upon receiving of the fourth instruction, the voltage transformation module 33 stops operating, to stop inputting the charging current to the first battery 41, stopping the charging of the first battery 41.

After sending the fourth instruction to the voltage transformation module 33, the control module 31 determines that the first trigger condition is met and sends the first instruction to the measurement module 32. Upon receiving of the first instruction, the measurement module 32 starts operating, to input the excitation signal to the first battery 41, and begin measuring the EIS of the first battery 41.

For example, the second trigger condition can be set as the charging apparatus 3 having been disconnected from the first battery 41. After the control module 31 sends the first instruction to the measurement module 32, if detecting that the connection between the charging output interface 37 and the charging input interface 42 is disconnected, the control module 31 determines that the connection between the charging apparatus 3 and the first battery 41 is disconnected, meeting the second trigger condition. At this time, the control module 31 can send the third instruction to the signal generator 22. Upon receiving of the third instruction, the measurement module 32 stops operating to stop outputting the excitation signal.

Alternatively, the second trigger condition can alternatively be set as the measurement duration. The control module 31 starts timing upon sending of the first instruction to the measurement module 32, and when the timed duration reaches the measurement duration, it determines that the second trigger condition is met. At this time, the control module 31 sends the third instruction to the measurement module 32, and upon receiving of the third instruction, the measurement module 32 stops inputting the excitation signal to the first battery 41. The measurement duration can be set according to needs, and this embodiment does not impose restrictions thereto.

It should be noted that during the process of inputting the excitation signal to the first battery before or after charging the first battery, the charging apparatus can also input the excitation signal to the first battery at preset intervals or in a case that a state of charge of the first battery reaches a preset threshold. The specific methods for inputting the excitation signal to the first battery can include but are not limited to the above examples.

In the embodiments of this application, the charging apparatus can input the excitation signal to the first battery before or after charging the first battery, to measure the EIS of the first battery before or after charging the first battery. During the measurement process, since the sampled current values and voltage values are not affected by the charging current, a relatively accurate electrochemical impedance spectrum can be measured.

In one embodiment, after inputting the excitation signal to the first battery 41 in the electric apparatus 4, the charging apparatus can sample the current in the circuit of the first battery 41 to obtain the current value sequence and acquire the voltage value sequence of the first battery from the electric apparatus, and then determine the electrochemical impedance spectrum of the first battery based on the current value sequence and the voltage value sequence.

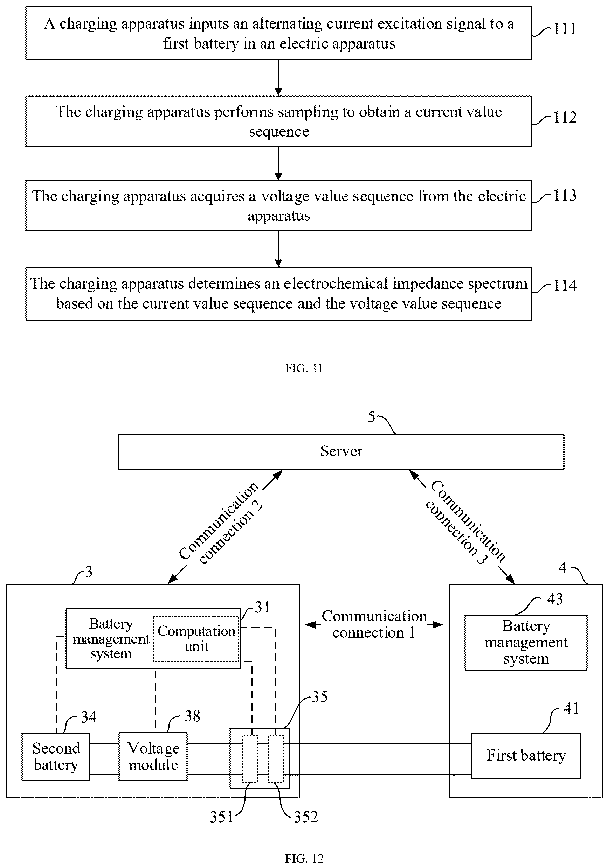

FIG. 11 is a flowchart of another electrochemical impedance spectrum measurement method according to an embodiment of this application. This method may be executed by a charging apparatus, for example, may be performed by a control module in the charging apparatus. As shown in FIG. 11, the method may include steps 111 to 114.

Step 111: The charging apparatus inputs an excitation signal to a first battery in an electric apparatus.

Step 112: The charging apparatus performs sampling to obtain a current value sequence.

Step 113: The charging apparatus acquires a voltage value sequence from the electric apparatus.

FIG. 12 is a schematic structural diagram of another electrochemical impedance spectrum measurement system according to an embodiment of this application. In the electric apparatus, the battery management system 43 can manage the first battery 41, and continuously monitor a voltage across two terminals of the first battery 41. When the first battery 41 includes multiple cells connected in series and/or parallel, the battery management system 43 can also continuously monitor a voltage across two terminals of each cell in the first battery 41.

As shown in FIG. 12, a communication connection 1 can be established between the charging apparatus 3 and the electric apparatus 4, and the charging apparatus 3 can acquire the voltage value sequence from the electric apparatus 4 through the pre-established communication connection 1. For example, the charging apparatus 3 and the electric apparatus 4 can establish the communication connection 1 through a controller area network (controller area network, CAN), daisy chain (flower chain) communication, telematics box (telematics box), or other communication methods. The charging apparatus 3 can communicate with the electric apparatus 4 through the communication connection 1 to acquire the voltage value sequence from the electric apparatus 4.

For another example, the charging apparatus 3 can establish a communication connection 2 to a server 5 through the internet, and the electric apparatus 4 can establish a communication connection 3 to the server 5 through the internet. The charging apparatus 3 and the electric apparatus 4 can interact through the communication connection 2 and the communication connection 3. After acquiring the voltage value sequence, the electric apparatus 4 can send the voltage value sequence to the server 5, and the server 5 can send the voltage value sequence to the electric apparatus 4.

The above are only exemplary examples, and the specific communication methods between the charging apparatus 3 and the electric apparatus 4 can include but are not limited to the above examples.

In one embodiment, only one voltage value sequence is acquired by the charging apparatus 3 from the electric apparatus 4, and the voltage values in this voltage value sequence are the voltage values across two terminals of the first battery 41. After establishing an electrical connection to the first battery 41, the electric apparatus 4 samples the voltages across the two terminals of the first battery 41 at a preset sampling frequency to obtain the voltage value sequence. After obtaining the voltage value sequence, the electric apparatus 4 can send the voltage value sequence to the charging apparatus 3 through the communication connection 1. Alternatively, the electric apparatus 4 can send the voltage value sequence to the charging apparatus 3 through the communication connection 2 and the communication connection 3.

In another embodiment, multiple voltage value sequences are acquired by the charging apparatus 3 from the electric apparatus 4, each voltage value sequence corresponding to one cell in the first battery 41, and the voltage values in the voltage value sequence are the voltage values across two terminals of the corresponding cell. For example, when the first battery 41 includes N cells, the electric apparatus 4 can sample the voltage across two terminals of each cell at a preset sampling frequency, to obtain one voltage value sequence corresponding to each cell, resulting in a total of N voltage value sequences. After obtaining the N voltage value sequences, the electric apparatus 4 can send the N voltage value sequences to the charging apparatus 3.

It should be noted that the electric apparatus 4 can alternatively sample the voltages across two terminals of only some of the cells, to obtain the corresponding voltage value sequences and send them to the charging apparatus 3.

In another embodiment, the charging apparatus 3 can acquire the voltage value sequences corresponding to each cell from the electric apparatus 4, and also acquire the voltage value sequence across the two terminals of the first battery 41 from the electric apparatus 4. For example, when the first battery 41 includes N cells, the battery management system 43 can acquire the voltage value sequence of each cell and the voltage value sequence across the two terminals of the first battery 41 to obtain (N+1) voltage value sequences, and send the (N+1) voltage value sequences to the charging apparatus 3.

When the voltage value sequence is obtained through sampling by the electric apparatus 4, the charging apparatus 3 can also sample, through the current sensor, the current values input to the charging output interface 37 at a preset sampling frequency to obtain the current value sequence. The sampling frequencies of the charging apparatus 3 and the electric apparatus 4 are the same.

Similarly, when acquiring the voltage value sequence through the electric apparatus 4, the charging apparatus 3 can input the first identification signal to the first battery 41 before inputting the excitation signal to the first battery 41, and input the second identification signal to the first battery 41 after inputting the excitation signal to the first battery 41.

Step 114: The charging apparatus determines an electrochemical impedance spectrum based on the current value sequence and the voltage value sequence.

In this embodiment, after acquiring the voltage value sequence composed of the voltage values across the two terminals of the first battery 41 from the electric apparatus 4, the charging apparatus 3 can determine the EIS of the first battery based on the acquired voltage value sequence and the sampled current value sequence. This EIS is the overall electrochemical impedance spectrum of the first battery 41.

When the charging apparatus 3 acquires the voltage value sequences corresponding to the cells in the first battery 41 from the electric apparatus 4, the charging apparatus 3 can determine the EIS based on the voltage value sequences corresponding to the cells and the current value sequence. This EIS is the electrochemical impedance spectrum of the cells.

It can be understood that when the electric apparatus 4 sends multiple voltage value sequences to the charging apparatus 3, the charging apparatus 3 can determine one electrochemical impedance spectrum based on each voltage value sequence and the current value sequence. When the voltage value sequence is the voltage value sequence across the two terminals of the first battery 41, the electrochemical impedance spectrum is the electrochemical impedance spectrum across the two terminals of the first battery 41; when the voltage value sequence is the voltage value sequence across two terminals of one cell in the first battery 41, the electrochemical impedance spectrum is the electrochemical impedance spectrum of the cell.

In the embodiments of this application, the voltage value sequence can be acquired through the electric apparatus. Since the electric apparatus can acquire the voltage value sequences corresponding to the cells in the first battery, the electrochemical impedance spectrum of the cells can be determined based on the voltage value sequences, allowing the state of the first battery to be precisely determined down to the cell level, thereby achieving a more accurate judgment of the state of the first battery.

In one embodiment, the current value sequence can also be acquired by the electric apparatus 4 and sent to the charging apparatus 3. As shown in FIG. 12, the battery management system 43 can sample the current input to the first battery 41 at a preset sampling frequency to obtain the current value sequence, and send the current value sequence to the charging apparatus 3.

In another embodiment, after inputting the excitation signal to the first battery 41 in the electric apparatus 4, the charging apparatus 3 can sample the current in the loop of the first battery 41 to obtain the current value sequence, and send the current value sequence to the server 5. Also, the electric apparatus 4 can acquire the voltage value sequence of the first battery 41 and send the voltage value sequence to the server 5. After receiving the voltage value sequence and the current value sequence, the server 5 can determine the electrochemical impedance spectrum of the first battery 41 based on the current value sequence and the voltage value sequence.

In one embodiment, both the current value sequence and the voltage value sequence can be sampled by the electric apparatus 4 and then sent to the charging apparatus. For example, the electric apparatus 4 can also be equipped with a current sensor and a voltage sensor, the current sensor can sample the currents input to the first battery at a preset sampling frequency to obtain the current value sequence, and the voltage sensor can sample the voltages across the two terminals of the first battery at a preset sampling frequency to obtain the voltage value sequence.

In another embodiment, one of the current value sequence and the voltage value sequence of the first battery is sampled by the charging apparatus 3, and the other is sampled by the electric apparatus 4 and then sent to the charging apparatus 3. For example, the current value sequence can be sampled by the current sensor in the charging apparatus 3, and the voltage value sequence can be sampled by the voltage sensor in the electric apparatus 4 and then sent to the charging apparatus 3. The methods for the charging apparatus to acquire the voltage value sequence and the current value sequence can include but are not limited to the above examples.

In the embodiments of this application, when the voltage value sequence and the current value sequence of the first battery are obtained through sampling by the electric apparatus, since the voltage values and current values sampled by the electric apparatus are relatively accurate, the EIS calculated based on the voltage value sequence and the current value sequence can be improved. When one of the voltage value sequence and the current value sequence is sampled by the electric apparatus and the other is sampled by the charging apparatus, the sampling method for the voltage values and current values can be flexibly set according to needs.

In one embodiment, the charging apparatus can send the acquired current value sequence and/or voltage value sequence of the first battery to a server.

This embodiment provides a measurement system including a charging apparatus, an electric apparatus, and a server. The charging apparatus is configured to input an excitation signal to a first battery in the electric apparatus, the server is configured to acquire a current value sequence and a voltage value sequence, and the server is further configured to determine an electrochemical impedance spectrum based on the current value sequence and the voltage value sequence.

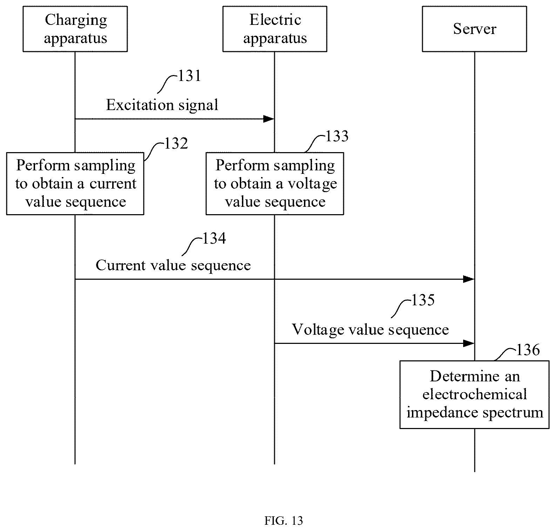

FIG. 13 is a flowchart of still another electrochemical impedance spectrum measurement method according to an embodiment of this application. As shown in FIG. 13, the method may include steps 131 to 136.

Step 131: A charging apparatus inputs an excitation signal to a first battery in an electric apparatus.

Step 132: The charging apparatus performs sampling to obtain a current value sequence.

Step 133: The electric apparatus performs sampling to obtain a voltage value sequence.

Step 134: The charging apparatus sends the current value sequence to a server.

Step 135: The electric apparatus sends the voltage value sequence to the server.

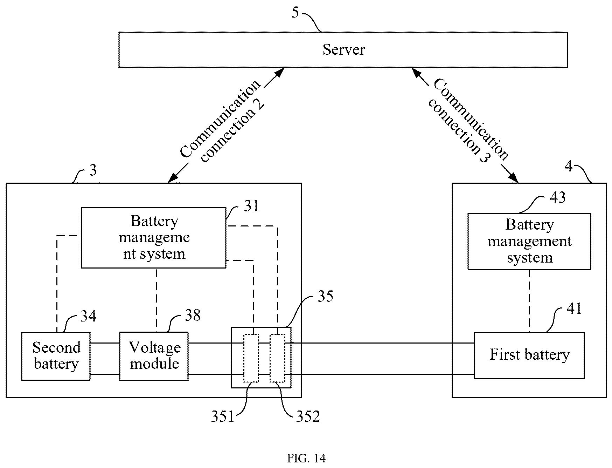

FIG. 14 is a schematic structural diagram of still another electrochemical impedance spectrum measurement system according to an embodiment of this application. After connected to a first battery 41, a charging apparatus 3 can sample currents output to a charging output interface 37 to obtain a current value sequence. After the current value sequence is obtained, the charging apparatus 3 sends the current value sequence to a server 5 through a communication connection 2.

During a process of sending the current value sequence to the server 5, the charging apparatus 3 can first send the current value sequence to an electric apparatus 4, and then the electric apparatus 4 forwards the current value sequence to the server 5.

As shown in FIG. 14, the electric apparatus 4 can sample voltages across two terminals of the first battery 41 to obtain the voltage value sequence and/or sample voltages across two terminals of each cell in the first battery 41 to obtain a voltage value sequence of each cell. After the voltage value sequence is obtained, the electric apparatus 4 sends the voltage value sequence to the server 5 through a communication connection 3.

In some embodiments, when sending the voltage value sequence to the server 5, the electric apparatus 4 can first send the voltage value sequence to the charging apparatus 3, and then the charging apparatus 3 forwards the voltage value sequence to the server 5.

Step 136: The server determines an electrochemical impedance spectrum based on the current value sequence and the voltage value sequence.

For the method for the server to determine the electrochemical impedance spectrum based on the voltage value sequence and the current value sequence, reference may be made to the method for the charging apparatus, and details are not described in this embodiment.

In the embodiments of this application, the charging apparatus sends one or both of the voltage value sequence and the current value sequence to the server, and the server determines the electrochemical impedance spectrum of the first battery based on the current value sequence and the voltage value sequence, reducing the computational load on the charging apparatus.

In this embodiment, when sending the current value sequence to the server 5, the charging apparatus 3 can mark the current value sequence as the current value sequence corresponding to the first battery 41. Similarly, when sending the voltage value sequence to the server 5, the electric apparatus 4 can mark the voltage value sequence as the voltage value sequence of the first battery 41. When calculating the electrochemical impedance spectrum, the server 5 determines the electrochemical impedance spectrum of the first battery 41 based on the voltage value sequence and the current value sequence with the same mark. The method for marking the current value sequence and the voltage value sequence can be specifically set according to needs, and this embodiment does not impose restrictions thereto.

In the embodiments of this application, the charging apparatus inputs the excitation signal to the battery in the electric apparatus, and the server determines the electrochemical impedance spectrum based on the voltage value sequence and the current value sequence of the first battery. This eliminates the need to configure a separate detection apparatus for the battery, thereby reducing the electrochemical impedance spectrum measurement cost. Moreover, the server directly determines the electrochemical impedance spectrum through calculation, facilitating the server in determining the state of the battery in the electric apparatus based on the electrochemical impedance spectrum, thereby implementing effective management of the electric apparatus based on the apparatus of the battery.

Optionally, for a case that the charging apparatus 3 inputs the excitation signal to the first battery 41 while inputting the charging current to the first battery 41, when determining the EIS based on the voltage value sequence and the current value sequence, the server 5 can extract the alternating voltage component from the voltage value sequence and extract the alternating current component from the current value sequence, to determine the EIS based on the alternating voltage component and the alternating current component.

Optionally, when the charging apparatus 3 inputs the excitation signal to the first battery 41 before or after inputting the charging current to the first battery 41, the charging apparatus 3 and the electric apparatus 4 can send only the current value sequence and the voltage value sequence sampled when the excitation signal is input to the first battery 41 to the server 4, and the server 5 can directly determine the EIS based on the current value sequence and the voltage value sequence.

In one embodiment, the charging apparatus can send the current value sequence and the voltage value sequence to the server. For example, when sending the voltage value sequence to the server 5, the electric apparatus 4 can first send the voltage value sequence to the charging apparatus 3, and then the charging apparatus 3 forwards the voltage value sequence to the server 5. Alternatively, the charging apparatus 3 can perform sampling to obtain the current value sequence and the voltage value sequence, and send the current value sequence and the voltage value sequence to the server 5.

In practical applications, the current value sequence can be sampled by the charging apparatus 3 and sent to the server 5, and the voltage value sequence can be sampled by the electric apparatus 4 and sent to the server 5. Alternatively, the current value sequence and the voltage value sequence can be sampled by the charging apparatus 3 and sent to the server 5. Alternatively, the current value sequence and the voltage value sequence can be sampled by the electric apparatus 4 and sent to the server 5.

In the embodiments of this application, the charging apparatus inputs the excitation signal to the battery in the electric apparatus and determines the electrochemical impedance spectrum based on the excitation signal. During measurement of the electrochemical impedance spectrum of the battery, there is no need to configure a separate detection apparatus for the battery, thereby reducing the electrochemical impedance spectrum measurement cost. Additionally, the connection between the charging apparatus and the electric apparatus is a conventional connection, and the operation is relatively simple, so the EIS measurement method provided in the embodiments of this application is highly practical in actual applications.

Additionally, according to the electrochemical impedance spectrum measurement method and the charging apparatus provided in the embodiments of this application, the electrochemical impedance spectrum of the battery can be measured each time the battery is charged, allowing frequent acquisition of the electrochemical impedance spectrum of the battery, thereby implementing timely detection of abnormality in the battery based on the electrochemical impedance spectrum upon occurrence of the abnormality.

This embodiment provides a measurement system including a charging apparatus and an electric apparatus. The charging apparatus is configured to input an excitation signal to a first battery in the electric apparatus, the electric apparatus is configured to acquire a current value sequence and a voltage value sequence, and the electric apparatus is further configured to determine an electrochemical impedance spectrum based on the current value sequence and the voltage value sequence.

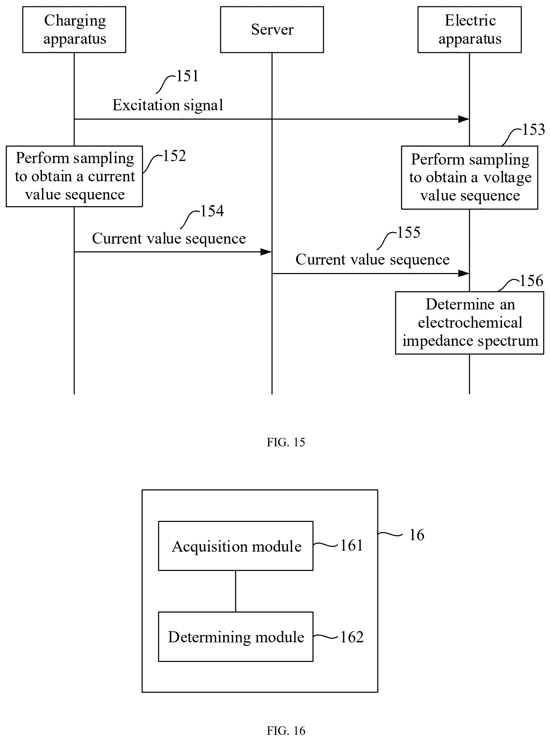

FIG. 15 is a flowchart of still another electrochemical impedance spectrum measurement method according to an embodiment of this application. As shown in FIG. 15, the method may include steps 151 to 156.

Step 151: A charging apparatus inputs an excitation signal to a first battery in an electric apparatus.

Step 152: The charging apparatus performs sampling to obtain a current value sequence.

Step 153: The electric apparatus performs sampling to obtain a voltage value sequence.

Step 154: The charging apparatus sends the current value sequence to a server.

Step 155: The server sends the current value sequence to the electric apparatus.

It can be understood that the charging apparatus can also directly establish a communication connection to the charging apparatus and directly send the current value sequence to the electric apparatus. Alternatively, the electric apparatus can directly perform sampling to obtain the current value sequence.

Step 156: The electric apparatus determines an electrochemical impedance spectrum based on the current value sequence and the voltage value sequence.

For the method for the electric apparatus to determine the electrochemical impedance spectrum based on the voltage value sequence and the current value sequence, reference may be made to the method for the charging apparatus, and details are not described in this embodiment.

In the embodiments of this application, the charging apparatus inputs the excitation signal to the battery in the electric apparatus, and the electric apparatus determines the electrochemical impedance spectrum based on the voltage value sequence and the current value sequence. This eliminates the need to configure a separate detection apparatus for the battery, thereby reducing the electrochemical impedance spectrum measurement cost. Moreover, the electric apparatus directly determines the electrochemical impedance spectrum, facilitating the electric apparatus in promptly obtaining a state of the battery based on the electrochemical impedance spectrum and adjusting a charging policy.

Optionally, the method may further include: outputting state information of the first battery, where the state information is determined based on the electrochemical impedance spectrum.

In this embodiment, after the EIS of the first battery is determined, the state information of the first battery can be determined based on the EIS of the first battery, and then the state information of the first battery can be output.

For example, during the process of determining the state information of the first battery based on the electrochemical impedance spectrum, a Nyquist plot (Nyquist plot) can be drawn based on the measured electrochemical impedance spectrum. The ohmic resistance, charge transfer resistance, double-layer capacitance at the electrode interface, and Warburg parameter of the first battery can be determined through the Nyquist plot. The diffusion coefficient of the electrode material in the first battery can be estimated based on the Warburg parameter.

The above are only exemplary examples, and the state information may further include the internal temperature, capacity, SOC, and SOH of the first battery, the conductivity information of the electrode material in the first battery, and the like. The specific method for determining the state information based on the electrochemical impedance spectrum can be set according to needs, and this embodiment does not impose restrictions thereto.

After the charging apparatus 3 and/or the electric apparatus 4 determines the EIS based on the voltage value sequence and the current value sequence, the EIS can be sent to the server 5, and the server 5 determines the state information of the first battery 41 based on the EIS and outputs the state information. Alternatively, the charging apparatus 3 and/or the electric apparatus 4 can directly determine the state information of the first battery 41 based on the EIS and output the state information.

After the server 5 determines the EIS based on the voltage value sequence and the current value sequence, the EIS can be sent to the charging apparatus 3 and/or the electric apparatus 4, and the charging apparatus 3 and/or the electric apparatus 4 determines the state information of the first battery 41 based on the EIS and outputs the state information. Alternatively, the server 5 can directly determine the state information of the first battery 41 based on the EIS and output the state information.

For example, if the charging apparatus 3 has a display screen, the charging apparatus 3 can output the state information of the first battery through the display screen. Alternatively, the charging apparatus 3 can also communicate with the electric apparatus 4 to output the state information of the first battery to the electric apparatus 4. Alternatively, the charging apparatus 3 can also communicate with a terminal device of a user (for example, a mobile phone) to output the state information of the first battery to the terminal device of the user.

For example, after determining the state information of the first battery 41, the server 5 can send the state information to the charging apparatus 3 and/or the electric apparatus 4, and the charging apparatus 3 and/or the electric apparatus 4 outputs the state information.

In one embodiment, the electric apparatus 4 can also send parameters such as the identification information, SOC, and battery type of the first battery 41 to the charging apparatus 3 and/or the server 5, and the charging apparatus and the server can output the related parameters of the first battery along with the state information.

The above are only exemplary examples, and the specific methods for outputting the state information can include but are not limited to the above examples.

In the embodiments of this application, after the electrochemical impedance spectrum of the first battery is determined, the state information of the first battery can be output based on the electrochemical impedance spectrum of the first battery. Since the state of the first battery can be accurately determined based on the electrochemical impedance spectrum, relatively accurate state information can be output based on the electrochemical impedance spectrum, facilitating users in judging the state of the first battery based on the state information.

Optionally, the method may further include: adjusting a charging policy of the first battery based on the electrochemical impedance spectrum.

In this embodiment, if the charging apparatus 3 inputs the excitation signal to the first battery 41 before inputting the charging current to the first battery 41, the ESI of the first battery 41 can be acquired before the charging apparatus 3 charges the first battery 41. In this case, the charging policy of the first battery 41 can be adjusted based on the EIS of the first battery 41.

If the charging apparatus 3 inputs the excitation signal to the first battery 41 during the process of inputting the charging current to the first battery 41, the ESI of the first battery 41 can also be acquired during the charging process of the first battery 41. In this case, the charging policy of the first battery 41 can be adjusted based on the EIS of the first battery 41.

When the charging apparatus 3 determines the EIS based on the voltage value sequence and the current value sequence, the charging apparatus 3 can directly adjust the charging policy of the first battery 41 based on the EIS. When the server 5 determines the EIS based on the voltage value sequence and the current value sequence, the server 5 can send the EIS to the charging apparatus 3 and/or the electric apparatus 4, and the charging apparatus 3 and/or the electric apparatus 4 adjusts the charging policy of the first battery 41 based on the received EIS.

For example, after obtaining the EIS of the first battery, if the charging apparatus 3 or the electric apparatus 4 determines, based on the EIS, that the internal temperature of the first battery 41 is excessively high, the charging current of the first battery 41 can be reduced. For another example, after obtaining the EIS of the first battery, the charging apparatus 3 or the electric apparatus 4 can determine the diffusion speed of the first battery based on the EIS of the first battery, and when it is determined that the diffusion speed of the first battery has decreased, the charging current of the first battery 41 can be reduced.

In one embodiment, after determining the EIS of the first battery 41, the server 5 can set the charging policy of the first battery 41 based on the EIS, and then the server 5 can send the charging policy of the first battery 41 to the charging apparatus 3 or the electric apparatus 4. After receiving the charging policy sent by the server 5, the charging apparatus 3 or the electric apparatus 4 charges the first battery 41 according to the charging policy, thereby allowing the server 5 to indirectly adjust the charging policy of the first battery 41.

In this embodiment, if the charging apparatus 3 inputs the excitation signal to the first battery 41 after inputting the charging current to the first battery 41, the charging apparatus 3 can acquire the ESI of the first battery 41 only after charging the first battery 41. In this case, the charging apparatus 3 can record the EIS of the first battery 41 and adjust the electrochemical impedance spectrum of the first battery based on the recorded EIS the next time it connects to the first battery 41.

The above are only exemplary examples, and the methods for adjusting the charging policy of the first battery based on the electrochemical impedance spectrum can include but are not limited to the above examples.

In the embodiments of this application, after the electrochemical impedance spectrum of the first battery is determined, the charging policy of the first battery can be adjusted based on the electrochemical impedance spectrum of the first battery. Since the state of the first battery can be determined relatively accurately based on the electrochemical impedance spectrum, adjusting the charging policy of the first battery based on the electrochemical impedance spectrum allows for more accurate control of the charging process of the first battery.

An embodiment of this application further provides an electrochemical impedance spectrum measurement apparatus. The charging apparatus includes, for example, the charging apparatus mentioned in the above examples. The charging apparatus includes a measurement module, where the measurement module is configured to input an excitation signal to a first battery in an electric apparatus.

In one embodiment, the measurement module is further configured to input an identification signal to the first battery.

In one embodiment, the measurement module is specifically configured to input the excitation signal to the first battery at preset intervals; or input the excitation signal to the first battery in a case that a state of charge of the first battery reaches a preset threshold.

In one embodiment, the measurement apparatus further includes:

an acquisition module configured to acquire a current value sequence and a voltage value sequence of the first battery; and

a determining module configured to determine an electrochemical impedance spectrum based on the current value sequence and the voltage value sequence.

In one embodiment, the measurement apparatus further includes: an adjustment module configured to adjust a charging policy of the first battery based on the electrochemical impedance spectrum.

In one embodiment, the measurement apparatus further includes: an output module configured to output state information of the first battery, where the state information is determined based on the electrochemical impedance spectrum.

In one embodiment, the measurement apparatus further includes: a sending module configured to send the acquired current value sequence and/or voltage value sequence of the first battery to a server.

In one embodiment, the measurement module includes a signal generator, where the signal generator is configured to generate an excitation signal and input the excitation signal to the first battery.

In one embodiment, the apparatus further includes a power source and a voltage transformation module; where the voltage transformation module has an input terminal connected to the power source, and an output terminal connected to the first battery, and is configured to transform a voltage from the power source to obtain and input a charging current to the first battery.

In one embodiment, the power source includes a second battery.

FIG. 16 is a schematic structural diagram of an electrochemical impedance spectrum measurement apparatus according to an embodiment of this application. The electrochemical impedance spectrum measurement apparatus 16 can be disposed in the server or charging apparatus mentioned in the above examples, and includes an acquisition module 161 and a determining module 162.

The acquisition module 161 is configured to acquire a current value sequence and a voltage value sequence, where the current value sequence includes current values of a first battery during a process of inputting an excitation signal to the first battery in an electric apparatus, the voltage value sequence includes voltage values of the first battery during the process of inputting the excitation signal to the first battery, and the excitation signal is input to the first battery by a charging apparatus;

The determining module 162 is configured to determine an electrochemical impedance spectrum of the first battery based on the current value sequence and the voltage value sequence.

In one embodiment, the measurement apparatus further includes: an adjustment module configured to adjust a charging policy of the first battery based on the electrochemical impedance spectrum.

In one embodiment, the measurement apparatus further includes: an output module configured to output state information of the first battery, where the state information is determined based on the electrochemical impedance spectrum.

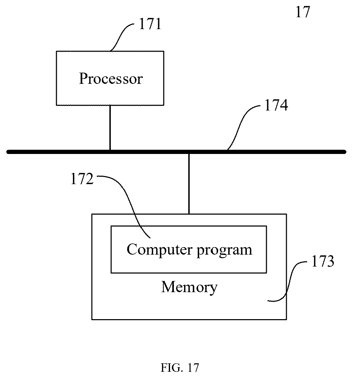

An embodiment of this application further provides an electrochemical impedance spectrum measurement apparatus. FIG. 17 is a structural block diagram of an electrochemical impedance spectrum measurement apparatus according to an embodiment of this application. As shown in FIG. 17, the electrochemical impedance spectrum measurement apparatus 17 includes a processor 171 and a memory 173, where the processor 171 and the memory 173 can be connected through one or more buses 174.

The electrochemical impedance spectrum measurement apparatus 17 further includes a computer program 172, where the computer program 172 is stored in the memory 173. When the computer program 172 is executed by the processor 171, the electrochemical impedance spectrum measurement apparatus 17 is caused to perform the electrochemical impedance spectrum measurement method mentioned in the above examples. For all relevant content of the steps involved in the above method embodiments, reference may be made to the function descriptions of the corresponding physical devices, and details are not described herein.

An embodiment of this application further provides a readable storage medium. The readable storage medium includes a computer program, which, when executed on a computer, causes the computer to perform the method provided in the above method embodiments.

An embodiment of this application further provides a computer program product containing instructions. When the computer program product is executed on a computer, the computer is caused to perform the method provided in the above method embodiments.

An embodiment of this application further provides a chip system including a memory and a processor, where the memory is configured to store a computer program, and the processor is configured to call and execute the computer program from the memory so as to cause a network apparatus installed with the chip system to perform the method provided in the above method embodiments.

The chip system may include an input circuit or interface for sending information or data, and an output circuit or interface for receiving information or data.

It should be understood that in the embodiments of this application, the processor may be a central processing unit (central processing unit, CPU), the processor may alternatively be another general-purpose processor, a digital signal processors (digital signal processor, DSP), an application-specific integrated circuit (application specific integrated circuit, ASIC), a field-programmable gate array (field programmable gate array, FPGA) or another programmable logic device, a discrete gate, a transistor logic device, a discrete hardware component, or the like. The general-purpose processor may be a microprocessor, or the processor may be any conventional processor or the like.

It should also be understood that the memory in the embodiments of this application may be a volatile memory or a non-volatile memory, or may include both volatile and non-volatile memories. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), which serves as an external cache. By way of example but not limitation, many forms of random access memories (random access memory, RAM) are usable, such as a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

Those of ordinary skill in the art can realize that the units and algorithm steps of the examples described in conjunction with the embodiments provided herein can be implemented by electronic hardware, or a combination of computer software and electronic hardware. Whether these functions are performed by hardware or software depends on the specific application and design constraints of the technical solution. Skilled technicians can use different methods to implement the described functions for each specific application, but such implementation should not be considered beyond the scope of this application.

Those skilled in the art can clearly understand that for the convenience and brevity of description, the specific working processes of the systems, apparatuses, and units described above can refer to the corresponding processes in the foregoing method embodiments, and will not be repeated herein.

In the several embodiments provided in this application, it should be understood that the disclosed systems, apparatuses, and methods can be implemented in other ways. For example, the apparatus embodiments described above are merely illustrative, for instance, the division of the units is only a logical function division, and there can be other division methods in actual implementation, such as multiple units or components can be combined or integrated into another system, or some features can be omitted or not executed. Another point is that the mutual coupling or direct coupling or communication connection shown or discussed can be through some interfaces, and the indirect coupling or communication connection of apparatuses or units can be electrical, mechanical, or other forms.

The units described as separate components may or may not be physically separate, and the components displayed as units may or may not be physical units, that is, they can be located in one place, or they can be distributed across multiple network units. Some or all of the units can be selected according to actual needs to achieve the purpose of the solution of this embodiment.

In addition, the functional units in the various embodiments of this application can be integrated into one processing unit, or each unit can exist physically separately, or two or more units can be integrated into one unit.

If the functions are implemented in the form of software functional units and sold or used as independent products, they can be stored in a computer-readable storage medium. Based on this understanding, the technical solution of this application, or the part that contributes to the prior art, or part of the technical solution can be embodied in the form of a software product, the computer software product being stored in a storage medium, including several instructions to cause a computer apparatus (which may be a personal computer, a server, a network device, or the like) to perform all or part of the steps of the methods described in the various embodiments of this application. The aforementioned storage medium includes: a USB flash drive, a portable hard disk, a read-only memory (Read-Only Memory, ROM), a random access memory (Random Access Memory, RAM), a magnetic disk, an optical disk, and other various media capable of storing program code.

The above are only specific implementations of this application, but the scope of protection of this application is not limited to this. Any person skilled in the art can easily think of changes or replacements within the technical scope disclosed in this application, which should be covered within the scope of protection of this application. Therefore, the scope of protection of this application should be subject to the scope of protection of the claims.

**Claims**

1.  An electrochemical impedance spectrum measurement method, wherein the method comprises:

    inputting an excitation signal to a first battery in an electric apparatus, wherein the excitation signal is used to measure an electrochemical impedance spectrum of the first battery;
    acquiring a current value sequence and a voltage value sequence, wherein the current value sequence comprises current values of the first battery during a process of inputting the excitation signal to the first battery, and the voltage value sequence comprises voltage values of the first battery during the process of inputting the excitation signal to the first battery; and
    determining the electrochemical impedance spectrum of the first battery based on the current value sequence and the voltage value sequence.

2.  The method according to claim 1, wherein the determining the electrochemical impedance spectrum of the first battery based on the current value sequence and the voltage value sequence comprises:

    in a case that the voltage value sequence comprises a voltage value corresponding to an identification signal, determining a voltage value subsequence corresponding to the excitation signal from the voltage value sequence;
    in a case that the current value sequence comprises a current value corresponding to an identification signal, determining a current value subsequence corresponding to the excitation signal from the current value sequence; and
    determining the electrochemical impedance spectrum based on the voltage value subsequence and the current value subsequence.

3.  The method according to claim 1 or 2, wherein after the determining the electrochemical impedance spectrum of the first battery based on the current value sequence and the voltage value sequence, the method further comprises:
    adjusting a charging policy of the first battery based on the electrochemical impedance spectrum.

4.  The method according to any one of claims 1 to 3, wherein after the determining the electrochemical impedance spectrum of the first battery based on the current value sequence and the voltage value sequence, the method further comprises:
    outputting state information of the first battery, wherein the state information is determined based on the electrochemical impedance spectrum.

5.  An electrochemical impedance spectrum measurement system, wherein the measurement system comprises: a charging apparatus and an electric apparatus; wherein

    the charging apparatus is configured to input an excitation signal to a first battery in the electric apparatus, wherein the excitation signal is used to measure an electrochemical impedance spectrum of the first battery;
    the charging apparatus is further configured to acquire a current value sequence and a voltage value sequence, wherein the current value sequence comprises current values of the first battery during a process of inputting the excitation signal to the first battery, and the voltage value sequence comprises voltage values of the first battery during the process of inputting the excitation signal to the first battery; and
    the charging apparatus is further configured to determine the electrochemical impedance spectrum based on the current value sequence and the voltage value sequence.

6.  The measurement system according to claim 5, wherein

    the charging apparatus is specifically configured to acquire the current value sequence and the voltage value sequence sampled by the electric apparatus from the electric apparatus;
    or, the charging apparatus is specifically configured to acquire one of the current value sequence and the voltage value sequence sampled by the electric apparatus from the electric apparatus and perform sampling to obtain the other of the current value sequence and the voltage value sequence;

or, the charging apparatus is specifically configured to perform sampling to obtain the current value sequence and the voltage value sequence.

7. An electrochemical impedance spectrum measurement system, wherein the measurement system comprises: a charging apparatus and an electric apparatus; wherein

the charging apparatus is configured to input an excitation signal to a first battery in the electric apparatus, wherein the excitation signal is used to measure an electrochemical impedance spectrum of the first battery;

the electric apparatus is configured to acquire a current value sequence and a voltage value sequence, wherein the current value sequence comprises current values of the first battery during a process of inputting the excitation signal to the first battery, and the voltage value sequence comprises voltage values of the first battery during the process of inputting the excitation signal to the first battery; and

the electric apparatus is further configured to determine the electrochemical impedance spectrum based on the current value sequence and the voltage value sequence.

8. The measurement system according to claim 7, wherein

the electric apparatus is specifically configured to acquire the current value sequence and the voltage value sequence sampled by the charging apparatus from the charging apparatus;

or, the electric apparatus is specifically configured to acquire one of the current value sequence and the voltage value sequence sampled by the charging apparatus from the charging apparatus and perform sampling to obtain the other of the current value sequence and the voltage value sequence;

or, the electric apparatus is specifically configured to perform sampling to obtain the current value sequence and the voltage value sequence.

9. An electrochemical impedance spectrum measurement system, wherein the measurement system comprises: a charging apparatus, an electric apparatus, and a server; wherein

the charging apparatus is configured to input an excitation signal to a first battery in the electric apparatus, wherein the excitation signal is used to measure an electrochemical impedance spectrum of the first battery;

the server is configured to acquire a current value sequence and a voltage value sequence, wherein the current value sequence comprises current values of the first battery during a process of inputting the excitation signal to the first battery, and the voltage value sequence comprises voltage values of the first battery during the process of inputting the excitation signal to the first battery; and

the server is further configured to determine the electrochemical impedance spectrum based on the current value sequence and the voltage value sequence.

10. The measurement system according to claim 9, wherein

the server is specifically configured to acquire the current value sequence and the voltage value sequence from the charging apparatus or the electric apparatus;

or, the server is specifically configured to acquire one of the current value sequence and the voltage value sequence sampled by the charging apparatus from the charging apparatus and acquire the other of the current value sequence and the voltage value sequence sampled by the electric apparatus from the electric apparatus.

11. The measurement system according to any one of claims 7 to 10, wherein the charging apparatus comprises a measurement module, wherein the measurement module is configured to connect to the first battery to input the excitation signal to the first battery.

12. The measurement system according to claim 11, wherein the measurement module comprises a signal generator for generating the excitation signal.

13. The measurement system according to any one of claims 7 to 12, wherein the charging apparatus further comprises a power source and a voltage transformation module; wherein the voltage transformation module has an input terminal connected to the power source, and an output terminal connected to the first battery, and is configured to transform a voltage from the power source to obtain and input a charging current to the first battery.

14. The measurement system according to claim 13, wherein the power source comprises a second battery.

**15.** An electrochemical impedance spectrum measurement method, applied to a charging apparatus, wherein the method comprises:

inputting an excitation signal to a first battery in an electric apparatus;
wherein the excitation signal is used to measure an electrochemical impedance spectrum of the first battery.

**16.** The method according to claim 15, wherein before the inputting an excitation signal to a first battery in an electric apparatus, the method further comprises:
inputting a first identification signal to the first battery, wherein the first identification signal is used to identify the start of inputting the excitation signal to the first battery.

**17.** The method according to claim 15 or 16, wherein after the inputting an excitation signal to a first battery in an electric apparatus, the method further comprises:
inputting a second identification signal to the first battery, wherein the second identification signal is used to identify the stop of inputting the excitation signal to the first battery.

**18.** The method according to claim 16 or 17, wherein duration of the identification signal input by the charging apparatus to the first battery is greater than or equal to a preset number of sampling periods of the excitation signal.

**19.** The method according to claim 18, wherein the preset number is 3.

**20.** The method according to any one of claims 16 to 19, wherein the identification signal input by the charging apparatus to the first battery comprises any one of a single-pulse signal, a multi-pulse signal, a step signal, a triangular wave signal, and a trapezoidal wave signal.

**21.** The method according to any one of claims 15 to 20, wherein the inputting an excitation signal to a first battery in an electric apparatus comprises:

inputting the excitation signal to the first battery at preset intervals;
or, inputting the excitation signal to the first battery in a case that a state of charge of the first battery reaches a preset threshold.

**22.** The method according to any one of claims 15 to 21, wherein the method further comprises:

acquiring a current value sequence and a voltage value sequence of the first battery; and

determining the electrochemical impedance spectrum based on the current value sequence and the voltage value sequence.

**23.** The method according to claim 22, wherein the acquiring a current value sequence and a voltage value sequence of the first battery comprises:

acquiring the current value sequence and the voltage value sequence sampled by the electric apparatus from the electric apparatus;
or, acquiring one of the current value sequence and the voltage value sequence sampled by the electric apparatus from the electric apparatus and performing sampling to obtain the other of the current value sequence and the voltage value sequence;
or, performing sampling to obtain the current value sequence and the voltage value sequence.

**24.** The method according to any one of claims 15 to 21, wherein the method further comprises:
sending the acquired current value sequence and/or voltage value sequence of the first battery to a server.

**25.** An electrochemical impedance spectrum measurement method, wherein the method comprises:

acquiring a current value sequence and a voltage value sequence, wherein the current value sequence comprises current values of a first battery during a process of inputting an excitation signal to the first battery in an electric apparatus, the voltage value sequence comprises voltage values of the first battery during the process of inputting the excitation signal to the first battery, and the excitation signal is input to the first battery by a charging apparatus; and
determining an electrochemical impedance spectrum of the first battery based on the current value sequence and the voltage value sequence.

**26.** The method according to claim 25, wherein the determining an electrochemical impedance spectrum of the first battery based on the current value sequence and the voltage value sequence comprises:

in a case that the voltage value sequence comprises a voltage value corresponding to an identification signal, determining a voltage value subsequence corresponding to the excitation signal from the voltage value sequence;
in a case that the current value sequence comprises a current value corresponding to an identification signal, determining a current value subsequence corresponding to the excitation signal from the current value sequence; and determining the electrochemical impedance spectrum based on the voltage value subsequence and the current value subsequence.

27. The method according to claim 25 or 26, wherein the method is applied to a server, and the acquiring a current value sequence and a voltage value sequence comprises:

acquiring the current value sequence and the voltage value sequence from the electric apparatus or the charging apparatus; or, acquiring the current value sequence from one of the electric apparatus and the charging apparatus and acquiring the voltage value sequence from the other.

28. The method according to any one of claims 25 to 27, wherein after the determining an electrochemical impedance spectrum of the first battery based on the current value sequence and the voltage value sequence, the method further comprises: adjusting a charging policy of the first battery based on the electrochemical impedance spectrum.

29. The method according to any one of claims 25 to 28, wherein after the determining an electrochemical impedance spectrum of the first battery based on the current value sequence and the voltage value sequence, the method further comprises: outputting state information of the first battery, wherein the state information is determined based on the electrochemical impedance spectrum.

30. An electrochemical impedance spectrum measurement apparatus, wherein the apparatus comprises a measurement module; and

the measurement module is configured to input an excitation signal to a first battery in an electric apparatus; wherein the excitation signal is used to measure an electrochemical impedance spectrum of the first battery.

31. The apparatus according to claim 30, wherein the measurement module comprises a signal generator for generating the excitation signal.

32. The apparatus according to claim 30 or 31, wherein the apparatus further comprises a power source and a voltage transformation module; wherein the voltage transformation module has an input terminal connected to the power source, and an output terminal connected to the first battery, and is configured to transform a voltage from the power source to obtain and input a charging current to the first battery.

33. The apparatus according to claim 32, wherein the power source comprises a second battery.

34. An electrochemical impedance spectrum measurement apparatus, wherein the measurement apparatus comprises:

an acquisition module configured to acquire a current value sequence and a voltage value sequence, wherein the current value sequence comprises current values of a first battery during a process of inputting an excitation signal to the first battery in an electric apparatus, the voltage value sequence comprises voltage values of the first battery during the process of inputting the excitation signal to the first battery, and the excitation signal is input to the first battery by a charging apparatus; and a determining module configured to determine an electrochemical impedance spectrum of the first battery based on the current value sequence and the voltage value sequence.

35. A readable storage medium, wherein the readable storage medium is configured to store a computer program, and when the computer program is executed by an electrochemical impedance spectrum measurement apparatus, the electrochemical impedance spectrum measurement apparatus is caused to perform the method according to any one of claims 1 to 4 or 15 to 29.

Detection apparatus

Signal generator

Current sensor

Voltage sensor

Battery

Computer

FIG. 1

Input an alternating current excitation signal to a first battery in the electric apparatus

21

Acquire a current value sequence and a voltage value sequence

22

Determine an electrochemical impedance spectrum of the first battery based on the current value sequence and the voltage value sequence

23

FIG. 2

Control module ~31

~3

Measurement module ~32

34
Power source

33~
Voltage transformation module

~35
Sensor module

FIG. 3

Battery management system ~31

~3

4~

Battery management system ~43

Signal generator ~32

36
34~
Second battery

33~
DCDC

~35
Sensor module

~37

42~

~41
First battery

FIG. 4

Controller _31_

Signal generator _32_

_34_ Power input port

_33_ Rectifier

_35_ Sensor module

_37_

_3_

_42_

_4_

Battery management system _43_

First battery _41_

FIG. 5

A charging apparatus inputs an excitation signal to a first battery in an electric apparatus _61_

The charging apparatus acquires a current value sequence and a voltage value sequence _62_

The charging apparatus determines an electrochemical impedance spectrum based on the current value sequence and the voltage value sequence _63_

FIG. 6

FIG. 7

FIG. 8

FIG. 9

FIG. 10

A charging apparatus inputs an alternating current excitation signal to a first battery in an electric apparatus ⌐111

The charging apparatus performs sampling to obtain a current value sequence ⌐112

The charging apparatus acquires a voltage value sequence from the electric apparatus ⌐113

The charging apparatus determines an electrochemical impedance spectrum based on the current value sequence and the voltage value sequence ⌐114

FIG. 11

5⌐

| Server |

Communication connection 2

Communication connection 3

⌐3

Communication connection 1

4⌐

Battery management system ┆ Computation unit ┆ ⌐31

Battery management system ⌐43

⌐34
Second battery

⌐38
Voltage module

⌐35

First battery ⌐41

351⌐ ⌐352

FIG. 12

FIG. 13

FIG. 14

Charging apparatus | Server | Electric apparatus

151
Excitation signal

152
Perform sampling to obtain a current value sequence

153
Perform sampling to obtain a voltage value sequence

154
Current value sequence

155
Current value sequence

156
Determine an electrochemical impedance spectrum

FIG. 15

16
Acquisition module — 161

Determining module — 162

FIG. 16

17

171

Processor

174

172

Computer program

173

Memory

FIG. 17

## INTERNATIONAL SEARCH REPORT

| International application No. |
|---|
| **PCT/CN2023/088722** |

**A. CLASSIFICATION OF SUBJECT MATTER**

G01R 31/389(2019.01)i

According to International Patent Classification (IPC) or to both national classification and IPC

**B. FIELDS SEARCHED**

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNTXT, DWPI, ENTXTC, CNKI: 宁德时代, 电池, 电化学阻抗谱, 激励, 电流值, 电压值, 序列, 充电, 放电, 服务器, 脉冲, 阶跃, 周期, 采样, EIS, sever, impedance spectrum, frequency, battery, current, voltage, excitation voltage

**C. DOCUMENTS CONSIDERED TO BE RELEVANT**

| Category* | Citation of document, with indication, where appropriate, of the relevant passages | Relevant to claim No. |
|---|---|---|
| X | CN 109828217 A (TSINGHUA UNIVERSITY) 31 May 2019 (2019-05-31) description, paragraphs [0064]-[0086], and figures 1-5 | 1-35 |
| X | CN 108663631 A (HARBIN INSTITUTE OF TECHNOLOGY) 16 October 2018 (2018-10-16) description, paragraphs [0024]-[0052], and figures 1-6 | 1-35 |
| X | CN 110837057 A (XI'AN JIAOTONG UNIVERSITY) 25 February 2020 (2020-02-25) description, paragraphs [0040]-[0088], and figures 1-5 | 1-35 |
| X | CN 111736082 A (HANGZHONG HUASU JADA TECHNOLOGY CO., LTD.) 02 October 2020 (2020-10-02) description, paragraphs [0025]-[0074], and figures 1-4 | 1-35 |
| X | CN 115308621 A (HUBEI UNIVERSITY OF TECHNOLOGY) 08 November 2022 (2022-11-08) description, paragraphs [0060]-[0089], and figures 1-10 | 1-35 |
| X | US 2023064240 A1 (CONTEMPORARY AMPEREX TECHNOLOGY CO., LTD.) 02 March 2023 (2023-03-02) description, paragraphs [0036]-[0122], and figures 1-9 | 1-35 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 December 2023** | **13 December 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

| International application No. |
| --- |
| **PCT/CN2023/088722** |

| Patent document cited in search report | | | Publication date (day/month/year) | Patent family member(s) | | | Publication date (day/month/year) |
| --- | --- | --- | --- | --- | --- | --- | --- |
| CN | 109828217 | A | 31 May 2019 | None | | | |
| CN | 108663631 | A | 16 October 2018 | CN | 108663631 | B | 25 December 2020 |
| CN | 110837057 | A | 25 February 2020 | CN | 110837057 | B | 13 April 2021 |
| CN | 111736082 | A | 02 October 2020 | CN | 111736082 | B | 13 November 2020 |
| CN | 115308621 | A | 08 November 2022 | None | | | |
| US | 2023064240 | A1 | 02 March 2023 | WO | 2023024034 | A1 | 02 March 2023 |
| | | | | US | 11650261 | B2 | 16 May 2023 |
| | | | | EP | 4166952 | A1 | 19 April 2023 |

Form PCT/ISA/210 (patent family annex) (July 2022)